# EUROPEAN PATENT SPECIFICATION

(11) **EP 1 110 238 B1**
(45) Date of publication and mention of the grant of the patent: **07.01.2009**
(21) Application number: 98938028.2
(22) Date of filing: 23.07.1998
(51) Int. Cl.: H01L 21/311

(54) **METHOD OF ETCHING DOPED SILICON DIOXIDE WITH SELECTIVITY TO UNDOPED SILICON DIOXIDE WITH A HIGH DENSITY PLASMA ETCHER**
ÄTZEN VON DOTIERTEM SIO2 MIT HOHER SELEKTIVITÄT ZU UNDOTIERTEM SIO2 MITTELS EINES PLASMAÄTZGERÄTES MIT HOHER DICHTE
PROCEDE PERMETTANT DE GRAVER DU DIOXYDE DE SILICIUM DOPE A L'AIDE D'UN GRAVEUR PLASMIQUE DE HAUTE DENSITE TOUT EN MAINTENANT UNE SELECTIVITE ENVERS LE DIOXYDE DE SILICIUM NON DOPE

(43) Date of publication of application: 27.06.2001
(73) Proprietor: Micron Technology, Inc., Boise, ID 83707-0006 (US)
(72) Inventor: KO, Kei-Yu, Meridian, ID 83642 (US)
(74) Representative: Craven, Ian
(86) International application number: PCT/US1998/015520
(87) International publication number: WO 2000/005756

(56) References cited:
- EP-A- 0 763 850
- US-A- 4 807 016
- US-A- 5 173 152
- US-A- 5 286 677
- US-A- 5 626 716
- TSAI W ET AL: "HIGH SELECTIVITY PLASMA ETCHING OF SILICON DIOXIDE WITH A DUAL FREQUENCY 27/2 MHZ CAPACITIVE RADIO FREQUENCY DISCHARGE" JOURNAL OF VACUUM SCIENCE AND TECHNOLOGY: PART B, vol. 14, no. 5, September 1996, pages 3276-3282, XP000636556
- YING ZHANG ET AL: "Fluorocarbon high density plasmas. VII. Investigation of selective SiO/sub 2/-to-Si/sub 3/N/sub 4/ high density plasma etch processes" JOURNAL OF VACUUM SCIENCE AND TECHNOLOGY: PART A, vol. 14, no. 4, July 1996, pages 2127-2137, XP002084384
- HOEK VAN DEN W G M ET AL: "ISOTROPIC PLASMA ETCHING OF DOPED AND UNDOPED SILICON DIOXIDE FOR CONTACT HOLES AND VIAS" JOURNAL OF VACUUM SCIENCE AND TECHNOLOGY: PART A, vol. 7, no. 3, PART 01, 1 May 1989, pages 670-675, XP000126078
- VENDER D ET AL: "SELECTIVE REACTIVE ION ETCHING OF PHOSPHORUS-DOPED OXIDE OVER UNDOPED SIO2" JOURNAL OF VACUUM SCIENCE AND TECHNOLOGY: PART A, vol. 11, no. 2, 1 March 1993, pages 279-285, XP000364352

## Description

### BACKGROUND OF THE INVENTION

### 1. The Field of the Invention

The present invention relates to removing doped silicon dioxide from a structure in a process that is selective to undoped silicon dioxide. More particularly, the present invention is directed to a method of using a high density plasma etcher such that doped silicon dioxide is removed from a structure at a material removal rate that is greater than that of undoped silicon dioxide.

### 2. The Relevant Technology

Modem integrated circuits are manufactured by an elaborate process in which a large number of electronic semiconductor devices are integrally formed on a semiconductor substrate. In the context of this document, the term "semiconductor substrate" is defined to mean any construction comprising semiconductive material, including but not limited to bulk semiconductive material such as a semiconductive wafer, either alone or in assemblies comprising other materials thereon, and semiconductive material layers, either alone or in assemblies comprising other materials. The term "substrate" refers to any supporting structure including but not limited to the semiconductive substrates described above. The term "doped silicon dioxide" refers to silicon dioxide having a dopant concentration greater than or equal to about 3% by weight. The term "undoped silicon dioxide" is defined as silicon dioxide having a dopant concentration less than about 3% by weight.

The semiconductor industry is attempting to increase the speed at which integrated circuits operate, to increase the density of devices on integrated circuits, and to reduce the price of integrated circuits. To accomplish this task, semiconductor devices, including capacitors, resistors, transistors, diodes, and the like, are continually being increased in number and decreased in dimension in a process known as miniaturization. In advanced manufacturing of integrated circuits, hundreds of thousands of these semiconductor devices are formed on a single semiconductor substrate. Efficient packing of these devices requires multilayer topographical design.

One common process for forming a topographical design on a semiconductor substrate involves etching of semiconductor material. The dimensional extent of material removal during an etch process is typically controlled by providing etch-resistant materials in predetermined regions of a semiconductor substrate. An etch-resistant structure that shields underlying material from an etch is known as an etch mask, while etch-resistant material positioned beneath material to be removed is an etch stop. In either case, the etch process is substantially selective to the etch stop or etch mask, while being not selective to the material to be removed.

In one common etching process, an etch-resistant masking layer is deposited and patterned over the semiconductor material to be etched. The pattern formed on the layer of masking material defines a series of openings in the masking material and corresponds to the topographical design to be formed during the etching process. Next, an etchant is applied to the semiconductor material through the pattern openings. A material, which may be doped silicon dioxide, is removed through the pattern openings, while the etch mask protects material positioned directly therebelow. Currently, photoresist material is commonly used as an etch mask. Use of photoresist material in an etch process involves forming, developing, and patterning the photoresist material, applying an etchant to etch the silicon dioxide, and then removing the photoresist material. The multiple steps involved in using photoresist material require time and resources that can increase the cost of producing integrated circuits.

In other applications, an etch-resistant material, such as silicon nitride is commonly used as an etch stop or etch mask material, particularly in connection with etch processes of silicon dioxide with a fluorinated etch chemistry. For example, in a conventional self-aligned etch process for forming a contact opening to an underlying active region on a semiconductor substrate, silicon nitride is usually used on top of a gate stack as an etch stop. The silicon nitride cap prevents overetching and ensures that the resulting contact hole is aligned directly atop the active region.

One of the problems in the prior art with forming a silicon nitride cap is the simultaneous formation of a silicon nitride layer on the back side of a semiconductor wafer. The particular problems depend on the process flow. For instance, where a low pressure chemical vapor deposition is used to deposit silicon nitride, both sides of the semiconductor wafer would receive deposits of silicon nitride. The presence of silicon nitride on the back side of the semiconductor wafer causes stress which deforms the shape of the semiconductor wafer, and can also potentially cause deformation of the crystal structure as well as cause defects in the circuit. Additionally, silicon nitride deposition is inherently a dirty operation having particulate matter in abundance which tends to reduce yield. When a low pressure chemical vapor deposition process is utilized, the silicon nitride layering on the back side of the semiconductor wafer must be removed later in the process flow.

It would be advantageous to have a method for providing an etch mask material that does not require removal after the etching is completed. Further, it would be an advancement in the art to provide an alternative to silicon nitride for use as an etch stop in self-aligned contact formation.

### SUMMARY OF THE INVENTION

The present invention relates to etching doped silicon dioxide from a structure in a process that is selective to undoped silicon dioxide.

Thus viewed from one aspect the present invention provides a method for removing doped silicon dioxide, said process comprising:
providing a structure including a first portion substantially composed of doped silicon dioxide and a second portion substantially composed of undoped silicon dioxide, wherein the doped silicon dioxide has a dopant concentration greater than or equal to about 3% by weight and the undoped silicon dioxide has a dopant concentration less than about 3% by weight; and
exposing both of said first portion and said second portion to a high density plasma etch process to selectively remove doped silicon dioxide from said first portion at a material removal rate that is greater than the material removal rate of undoped silicon dioxide from said second portion, wherein the high density plasma etch process comprises an ion density of greater than about 109 ions/cm3 and a source power density of less than about 1000 Watts per 200 mm-diameter wafer surface.

A structure may be provided having a first region substantially composed of doped silicon dioxide and a second region substantially composed of undoped silicon dioxide. The first and second regions may be configured to define a topographical structure to be formed by the selective etch process. A high density plasma system may be used to remove doped silicon dioxide from the topographical structure.

A high density plasma system, as defined herein, has two electrodes. The two electrodes are the upper electrode and lower electrode. There is a space or gap between the two electrodes. The upper electrode is sometimes referred to as the upper window. An inductively coupled plasma is usually applied to the upper electrode (or upper window). Sometimes, the power that is applied to the upper electrode can be divided into two parts, such as an outer coil and an inner coil. The power that is applied to the upper electrode is usually referred to, and is referred to herein, as the source power.

A semiconductor substrate of wafer being etched is situated on the lower electrode where an option RF power is usually applied to. This power is usually referred as to the bias power. The etch under these condition has a plasma density not less than about 10⁹ cm⁻³, and the operating pressure is usually at 1.33Pa (10 Millitorr (mT)) or below.

A high density plasma source with a fluorinated etch chemistry is applied to the structure such that an inductively-coupled power is delivered to the upper electrode in an amount less than about 1000 Watts (W) per 200 mm-diameter wafer surface. Stated otherwise, the source power density can be expressed as an amount less than about 0.032 W/mm² or 19.89 W/in². Accordingly, doped silicon dioxide is removed from the structure at a material removal rate that is greater than the rate of removal of undoped silicon dioxide.

In a reactive ion etcher (RIE), only the bottom electrode where the wafer is situated is powered. Thus, the bottom electrode is preferably the same size as the wafer. As such, the power density is defined as the ratio between the power and the wafer surface area. In a high density etcher, however, the source power which generates a plasma in the etcher is applied to the upper electrode or upper window. A coil is situated on the upper window. There is generally no definite shape or size of the coil that sits on the upper window and the size or volume of the plasma zone is not necessarily the same as the size of the coil. As such, the power density is defined as the source power applied to the upper window over the surface area of the wafer situated upon the bottom electrode.

The method of the invention extends to any structure from which doped silicon dioxide may be removed selectively to undoped silicon dioxide. The invention has been found particularly advantageous for use in semiconductor structure fabrication. In one embodiment, a doped silicon dioxide layer is formed over a semiconductor substrate. An undoped silicon dioxide layer is then formed over the doped silicon dioxide and patterned to provide one or more openings therein extending to the doped silicon dioxide layer. The high density plasma etch process described above is conducted, thereby selectively removing doped silicon dioxide through the openings in the pattern and forming a predetermined topographical structure. The undoped silicon dioxide layer acts as an etch mask during the etching process. Under this embodiment, the undoped silicon dioxide etch mask does not need to be removed after the etching process is completed.

According to another embodiment of the invention, the positions of the doped and the undoped silicon dioxide layers within the structure are reversed. The undoped silicon dioxide layer is formed over the semiconductor substrate, with the doped silicon dioxide layer formed thereupon. Photoresist is deposited and patterned on doped silicon dioxide to provide openings. The high density plasma etch is directed onto the structure, thereby removing doped silicon dioxide to form an opening that terminates at the undoped silicon dioxide layer.

The invention is useful with a variety of applications wherein doped silicon dioxide is etched from a semiconductor structure. For example, undoped silicon dioxide layers may be positioned both over and under a doped silicon dioxide layer. Alternatively, the invention may be used for forming a self-aligned contact hole to a contact surface on a semiconductor substrate. The self-aligned contact hole is formed by first providing a multilayer structure over the semiconductor substrate that comprises a thin silicon dioxide layer, a layer of conductor material, and a refractory metal silicide layer. By way of example, the multilayer structure may include a gate oxide layer, a polysilicon layer, and a refractory metal silicide layer successively formed over a semiconductor substrate. An undoped silicon dioxide layer is then formed over the multilayer structure.

The multilayer structure is patterned to form the designated topography, with openings extending to the semiconductor substrate. Doped silicon dioxide is next formed over the semiconductor substrate. A patterned etch mask layer is utilized to expose selected portions of the doped silicon dioxide layer that are intended to be etched. One example of a topographical structure created utilizing this process are gate stacks. A high density plasma etch as described above is conducted to selectively and anisotropically remove doped silicon dioxide such that a self-aligned contact opening extends to a contact surface on the semiconductor substrate between the gate stacks.

As can be seen, the present invention provides undoped silicon dioxide as an alternative to silicon nitride that has previously been used in many selective etch processes. In other applications, the use of photoresist material that must be removed after etching is reduced or eliminated under the invention. Further, the etching process of the invention may be conducted with high density plasma etchers.

### BRIEF DESCRIPTION OF THE DRAWINGS

In order that the manner in which the above-recited and other advantages and objects of the invention are obtained, a more particular description of the invention briefly described above will be rendered by reference to specific embodiments thereof which are illustrated in the appended drawings. Understanding that these drawings depict only typical embodiments of the invention and are therefore not to be considered limiting of its scope, the invention will be described with additional specificity and detail through the use of the accompanying drawings in which:
Figure 1 is a partial cross-sectional elevation view of a multilayer structure in a high density plasma etcher that is etched according to one embodiment of the invention. An undoped silicon dioxide layer is formed over a doped silicon dioxide layer and patterned. A high density plasma etch is conducted to selectively remove doped silicon dioxide.
Figure 2 is a partial cross-sectional elevation view of a preliminary step according to another embodiment of the invention, wherein an opening is formed in an undoped silicon dioxide layer.
Figure 3 is a partial cross-sectional elevation view of the structure of Figure 2. A doped silicon dioxide layer is formed and selectively removed with a high density plasma etch such that the underlying undoped silicon dioxide layer acts as an etch stop.
Figure 4 is a partial cross-sectional elevation view of a structure from which gate stacks are to be formed according to the invention.
Figure 5 is a partial cross-sectional elevation view of formation of a contact opening between a pair of gate stacks. The gate stacks have an upper undoped silicon dioxide layer and undoped silicon dioxide spacers to which a high density plasma etch is selective.
Figure 6 is a partial cross-sectional elevation view of another embodiment of the invention in which two contact openings are successively formed. Undoped silicon dioxide is used as both an etch stop and an etch mask during the formation of contact openings between pairs of gate stacks. A photoresist layer is used to substantially fill a second opening during etching through a first opening in an intermediate step of the process.
Figure 7 is a partial cross-sectional elevation view of a variation of the embodiment of Figure 5. An upper pair of gate stacks, each of which has an undoped silicon dioxide upper layer and an undoped silicon dioxide spacer, is positioned to be an etch mask for the high density plasma etch. A lower pair of gate stacks are positioned to be an etch stop and to form a self-aligned contact opening.

### DETAILED DESCRIPTION OF THE PREFERRED EMBODIMENTS

The present invention relates to etching doped silicon dioxide from a structure in a process that is selective to undoped silicon dioxide. According to the invention, a structure is provided having a first region substantially composed of doped silicon dioxide and a second region substantially composed of undoped silicon dioxide. The first and second regions are configured to define a topographical structure to be formed by the selective etch process. Often, the first and second regions will be in physical contact one with another. A high density plasma etch with a fluorinated etch chemistry is applied to the structure such that a power density is delivered to both of the first and second regions in an amount less than about 1000 W per 200-mm diameter wafer. Accordingly, doped silicon dioxide is removed from the structure at a material removal rate that is greater than the rate of removal of undoped silicon dioxide.

An important feature of the invention is the development of methods of removing doped silicon dioxide selective to undoped silicon dioxide using a high density plasma etch process. As used herein, "high density plasma etch" is any plasma etch conducted in a high density plasma etcher in which there is an ion density higher than about 10⁹ ions/cm³. This is contrasted with other plasma etch processes, such as reactive ion etching (RIE) and magnetically enhanced reactive ion etching (MERIE), which generally have ion densities in a range from about 10⁸ ions/cm³ to less than about 10⁹ ions/cm³. High density plasma etchers are notable for the high material removal rates which they produce. Typical high density plasma etch rates of silicon dioxide are in a range from about 500nm/min to about 1000nm/min (about 5,000 Å/min to about 10,000 Å/min). RIE processes ordinarily do not exceed about 500nm/min (5,000 Å/min).

As used herein,"material removal rate"is expressed as a unit length per unit time. A material removal rate as expressed herein is measured only over the amount of time during which a surface of the material is actually exposed to an etch chemistry. For example, if a certain embodiment includes a second layer exposed by etching an opening through a first layer, the material removal rate of the first layer is calculated only during the time in which the opening is being formed therein, while the material removal rate of the second layer is measured only during the time after which a surface thereof is exposed to an etch chemistry through the opening. This method of measuring material removal rates allows objective and consistent comparison between surfaces that may be exposed during different lengths of time.

High density etchers may be used in a range of operating parameters, including those of power density, which is defined as the energy rate delivered to a surface of a structure to be etched per unit area. In nearly all previous applications in the art, high density plasma etchers have been used at or near their maximum power density, in a range of about 1000 W per 200-mm diameter wafer or higher. This range of power density is referred to herein as "high power density." High density plasma etchers are also capable of delivering less energy, including "medium power density" which is herein defined as a range from less than about 1000 W per 200-mm diameter wafer and "low power density" which is herein defined as a range less than about 300 W per 200-mm diameter wafer. Thus, as the terms are used herein, high density plasma etch processes within high density plasma etchers may be conducted at a "medium power density" or a "high power density."

It might be expected that a reduction of power density in a high density plasma etch would significantly reduce the rate at which doped silicon dioxide is thereby removed. However, it has been found that the material removal rate of doped silicon dioxide in high density plasma etching is only a weak function of the power density applied thereto. In other words, a reduction of power density to doped silicon dioxide has been found to result in only a small or no reduction in the removal rate of doped silicon dioxide. It has also been observed that the material removal rate of undoped silicon dioxide is a strong function of power density. A reduction of power density in a high density plasma etch process significantly reduces the removal rate of undoped silicon dioxide.

At high power densities, there is little or no selectivity between doped and undoped silicon dioxide. However, as the removal rate of undoped silicon dioxide significantly drops at medium and low power densities, there is substantial selectivity between doped and undoped silicon dioxide. At medium and lower power density settings, doped silicon dioxide may be removed according to the invention at rates 10 times or more greater than the material removal rate of undoped silicon dioxide removal. While not fully understood, it is believed that deposition of polymers on exposed undoped silicon dioxide during the high density plasma etch plays some role in providing the selectivity to undoped silicon dioxide. Such polymers are generated during the chemical reactions between the etch chemistry and the material that is removed during the etch.

The general etch process according to the preferred embodiments of the invention is conducted by placing a wafer or other structure to be etched within a chamber of a high density plasma etcher. A typical wafer is roughly circular and has a diameter of about 203.2mm (8 inches). Medium and low power densities are generated by controlling the power supply delivered to an upper electrode and a lower electrode within the chamber of the high density plasma etcher. Accordingly, for a 203.2mm (8 inch) wafer, a source power is applied to the upper electrode in a range from about 500 Watts to about 1,000 Watts for medium power density or in a range less than about 500 Watts for low power density. A bias power, P_{B}, is delivered to the lower electrode at an amount defined as P₅ - 200 ≤ P_{B} ≤ P_{S} + 200, where Ps is the source power as defined above. Preferably, P_{S} - 100 ≤ P_{B} ≤ P_{S} + 100, and most preferably, the source power and the bias power are about equal.

The high density plasma etcher preferably uses a fluorinated etch chemistry selected from the group of C₂F₆, CF₄, C₃F₈, C₄F₁₀, CH₂F₂ CHF₃, C₂HF₅, CH₃F and combinations thereof. There are other fluorinated etchants in a substantially gas phase that can be employed during the etching of the structure. An inert gas is often used in combination with the fluorinated etchant. Argon, nitrogen, and helium are examples of such an inert gas. The most preferred gasses, however, are C₂HF₅, CH₂F₂, CHF₃ and Ar. Alternatively CH₃F may be used in place of CH₂F₂. In particular, preferred etchants include a fluorine deficient gas, which is defined as a gas without enough fluorine atoms to saturate the bonding for the carbon atoms.

As currently practiced, temperature during a high density plasma etch is controlled by cooling the lower electrode with a fluid, such as water, having a temperature in a range from about 0 °C to about 30 °C. Often, the upper limit of acceptable wafer temperatures is defined by the softening temperature of photoresist material at about 130 °C. The appropriate operating pressure is a function of the etch chemistry, among other factors, and will be understood by one skilled in the art. In most cases, however, the preferred pressure for a high density plasma etcher will be in a range from about 133mPa to about 1.33Pa (about 1 millitorr to about 10 millitorr).

The high density plasma etch with the associated medium and low power densities as disclosed above are generally applicable to the various embodiments of the inventive methods as described herein. In an example of an etch process by which doped silicon dioxide was removed from a structure at a rate at least 10 times greater than the removal rate of undoped silicon dioxide, a 203.2mm (8 inch) semiconductor wafer was placed within a high density plasma etcher. A source power of about 800 Watts was delivered to the upper electrode, and a bias power of about 800 Watts was applied to the lower electrode. The etch was conducted in a chemistry of C₂HF₅, CHF₃ and CH₂F₂, in a ratio of about 4 : 3 : 3, and at an operating pressure of about 399mPa (about 3 millitorr).

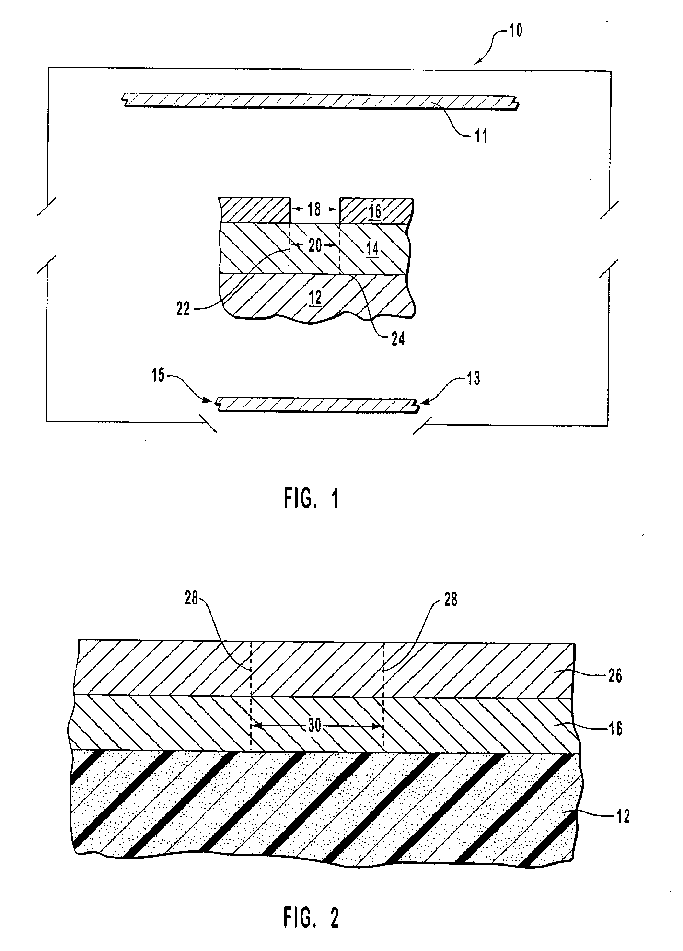

Figures 1-7 illustrate methods of the invention as directed to several structures that may be formed by removal of doped silicon dioxide selective to undoped silicon dioxide. Figure 1 shows a high density plasma etcher 10 having an upper electrode 11, a lower electrode 13, and a stream of a cooling fluid 15. A semiconductor substrate 12 that preferably comprises silicon, and may be substantially composed of monocrystalline silicon, is also illustrated in Figure 1. Overlying semiconductor substrate 12 is a first layer 14 substantially composed of doped silicon dioxide. Preferably, first layer 14 and other doped silicon dioxide structures disclosed herein are substantially composed of borophosphosilicate glass (BPSG), borosilicate glass (BSG), or phosphosilicate glass (PSG). Most preferably, first layer 14 is substantially composed of silicon dioxide having a boron dopant concentration of about 3% or more by weight and a phosphorus dopant concentration of about 3% or more by weight. For purposes of this disclosure "first layer" refers to a layer substantially composed of doped silicon dioxide.

A second layer 16 substantially composed of undoped silicon dioxide is formed over first layer 14. For purposes of this disclosure, "second layer" refers to a layer substantially composed of undoped silicon dioxide. The undoped silicon dioxide of second layer 16 may be formed, for example, by a thermal process, by a plasma enhanced deposition process, by conventional TEOS precursor deposition that is preferably rich in carbon or hydrogen, or by a precursor of gaseous silane (SiH₄) with oxygen. Second layer 16 is processed to form a first selected pattern 18 through which first layer 14 is exposed.

The structure seen in Figure 1 is then etched according to the high density plasma etch described above. The preferred etch removes doped silicon dioxide anisotropically from first layer 14 in a region aligned with first selected pattern 18 down to semiconductor substrate 12. The high density plasma etch will form an opening 20 (shown in phantom) having lateral dimensions substantially corresponding to those of first selected pattern 18. Moreover, opening 20 will be defined by a contact surface 24 situated on semiconductor substrate 12 and a sidewall 22 that is substantially orthogonal to semiconductor substrate 12. Second layer 16 prevents the high density plasma etch from removing material from first layer 14 except as aligned with first selected pattern 18. After formation of opening 20, a contact plug substantially composed of a conductive material may be formed within opening 20 to provide electrical connection between contact surface 24 and overlying layers. Such a contact plug is defined by first selected pattern 18 and opening 20 and is illustrated by phantom lines in Figure 1. The contact plug is formed according to well-understood processes in the art. Likewise, in other embodiments disclosed herein, a structure such a contact plug may be formed in contact openings that extend to a contact surface on a semiconductor substrate.

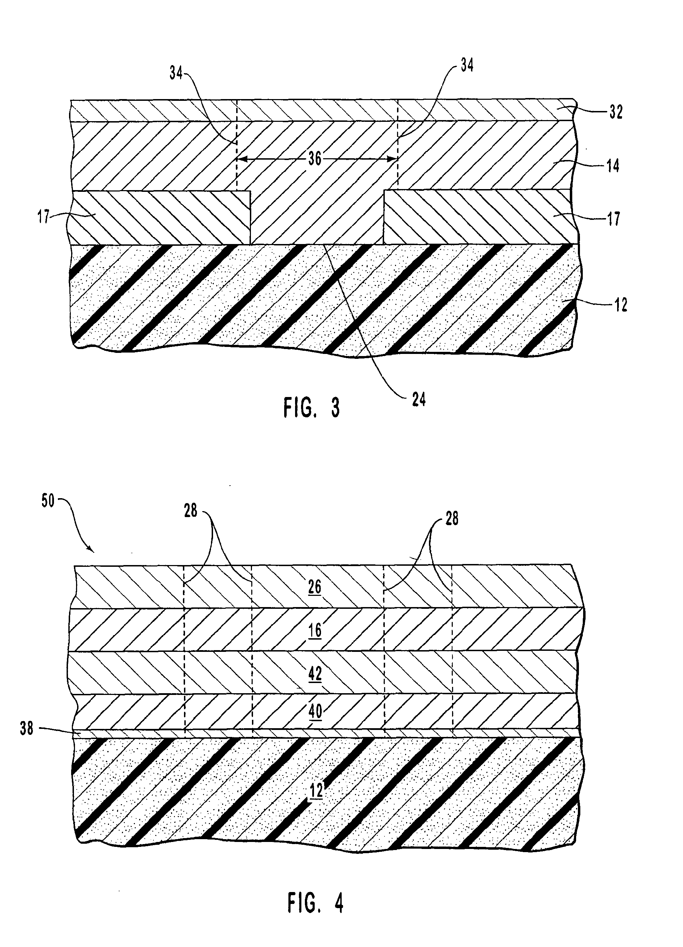

Figures 2 and 3 depict another structure to which the etch process of the invention is applied wherein doped silicon dioxide is formed over undoped silicon dioxide. As illustrated in Figure 2, a second layer 16 substantially composed of undoped silicon dioxide is formed over a semiconductor substrate 12. The undoped silicon dioxide may be formed by any conventional process, including a thermal process, a plasma enhanced deposition process, a conventional TEOS precursor deposition that is preferably rich in carbon or hydrogen, or a precursor of gaseous silane (SiH₄) with oxygen.

A photoresist layer 26 is formed over second layer 16 and patterned to produce a first selected pattern 28. Second layer 16 is then anisotropically etched through first selected pattern 28 to selectively remove undoped silicon dioxide therefrom. The anisotropic etch of second layer 16 may be any conventional etch process used in the art. Accordingly, opening 30 (shown in phantom) is formed through second layer 16, thereby exposing semiconductor substrate 12 and forming undoped silicon dioxide caps 17 as seen in Figure 3. A first layer 14 substantially composed of doped silicon dioxide is deposited over undoped silicon dioxide caps 17 and semiconductor substrate 12 as a passivation layer. An etch mask layer 32 is formed over first layer 14, and may be substantially composed of undoped silicon dioxide. Alternatively etch mask layer 32 may consist of a photoresist material or another suitable material that is resistant to a high density plasma etch. Etch mask layer 32 is patterned to form second selected pattern 34 substantially vertically aligned with opening 30.

The structure seen in Figure 3 is then etched according to the high density plasma etch of the invention as described above. The preferred etch removes doped silicon dioxide anisotropically from first layer 14 in a region aligned with second selected pattern 34 down to semiconductor substrate 12 and second layer 16. The high density plasma etch will form contact opening 36 having lateral dimensions substantially corresponding to those of second selected pattern 34 and opening 30. Undoped silicon dioxide caps 17 prevent overetching of contact opening 36, restricting the extent of exposure of semiconductor substrate 12 to contact surface 24 that is positioned between undoped silicon dioxide caps 17. Further, etch mask layer 32 prevents the high density plasma etch from removing material from first layer 14 except as aligned with second selected pattern 34. Accordingly, contact opening 36 is self-aligned with contact surface 24. The high density plasma etch of the invention that is selective to undoped silicon dioxide avoids the need to use silicon nitride as an etch stop structure.

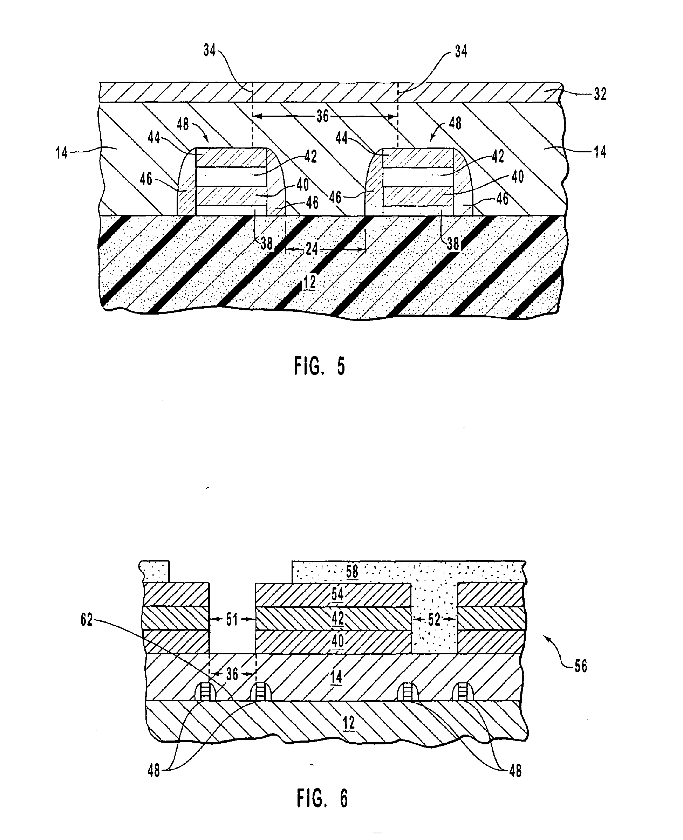

A further embodiment of the method of the invention is used to form one or more gate stacks as illustrated in Figures 4 and 5. A multilayer structure 50 is formed over semiconductor substrate 12. Multilayer structure 50 comprises a gate oxide layer 38 that covers semiconductor substrate 12. Gate oxide layer 38 may be relatively thin in comparison with the other layers of multilayer structure 50. A polysilicon layer 40 is formed over gate oxide layer 38. Overlying polysilicon layer 40 is a refractory metal silicide layer 42. A known benefit of refractory metal silicides is their low resistivity. Refractory metal silicide layer 42 for purposes of the invention described herein includes a silicide of at least one of titanium, chromium, tantalum, platinum, tungsten and zirconium, and also molybdenum. Preferably, refractory metal silicide layer 42 is substantially composed of tungsten silicide (WSiₓ).

Overlying refractory metal silicide layer 42 is a second layer 16 that is substantially composed of undoped silicon dioxide which can be formed by any known means including thermally, by plasma enhanced deposition, by a conventional TEOS precursor deposition that is preferably rich in carbon or hydrogen, or by a precursor of gaseous silane (SiH₄) with oxygen. Next, a photoresist layer 26 is provided and patterned over second layer 16 to form first selected pattern 28. Multilayer structure 50 is anisotropically etched through first selected pattern 28 to selectively remove material therefrom so as to form gate stacks 48 as illustrated in Figure 5. The etch of multilayer structure 50 may be any conventional etch process used in the art. Each gate stack 48 has an undoped silicon dioxide cap 44 thereon which is formed during the etch of second layer 16.

As depicted in Figure 5, a spacer 46 is positioned on a lateral surface of each gate stack 48. Spacers 46 are formed by subjecting a layer of silicon nitride deposited over gate stacks 48 to a spacer etch. Spacers 46 are generally perpendicular to semiconductor substrate 12. Alternatively, spacers 46 can be substantially composed of undoped silicon dioxide. As such, both spacers 46 and undoped silicon dioxide caps 44 can be made from the same materials and each acts as an etch stop.

Upon formation of gate stacks 48, a contact surface 24 is defined therebetween upon semiconductor substrate 12. At this point in the processing, a first layer 14, substantially composed of doped silicon dioxide, and preferably of a material such as PSG, BSG, or BPSG, is deposited over gate stacks 48 and semiconductor substrate 12. An etch mask layer 32 is then applied over first layer 14. Etch mask layer 32 is processed to create a second selected pattern 34 that is shown in phantom. The structure of Figure 5 is then etched according to the high density plasma etch of the invention as described above. The preferred etch removes doped silicon dioxide anisotropically from first layer 14 in a region aligned with second selected pattern 34 and between gate stacks 48 to expose contact surface 24. Undoped silicon dioxide caps 44 and spacers 46 prevent overetching into gate stack 48 and restrict exposure of semiconductor substrate 12 to contact surface 24. Accordingly, contact opening 36 is defined by contact surface 24 and by spacers 46.

Moreover, spacers 46 and undoped silicon dioxide cap 44 protect gate stacks 48 from the high density plasma etch. The etch removes doped silicon dioxide from first layer 14 at a material removal rate greater than that of undoped silicon dioxide cap 44 and silicon nitride or undoped silicon dioxide spacers 46. Preferably, the etch has a material removal rate for doped silicon dioxide is at least 10 times higher than that of undoped silicon dioxide. As such, contact opening 36 is self-aligned between spacers 46 of gate stacks 48. The self-aligning aspect of contact opening 36 is due to the selectivity of the etch which assures that even in cases of misalignment of second selected pattern 34, the high density plasma etch of first layer 14 will properly place contact opening 36 directly on contact surface 24 between adjacent spacers 46. The high density plasma etch also produces a material removal rate of doped silicon dioxide that is greater, and preferably at least 10 times greater, than removal rates of semiconductive material from semiconductor substrate 12, any silicon nitride that is found in spacers 46, and any photoresist material that is found in etch mask layer 32.

Figure 6 illustrates formation of a contact opening between a pair of gate stacks as conducted in Figures 4 and 5, with an additional structure formed over first layer 14. In general, etch mask layer 32 of Figure 5 is replaced with an upper multilayer structure 56 as seen in Figure 6. In particular, upper multilayer structure 56 comprises a polysilicon layer 40, a refractory metal silicide layer 42, and an undoped silicon dioxide layer 54 that are successively formed over first layer 14. A primary opening 51 and a secondary opening 52 as shown in Figure 6 are formed within upper multilayer structure 56. Primary opening 51 is positioned generally over one pair of gate stacks 48, while secondary opening 52 is located over another pair of gate stacks 48. Primary opening, 51 is provided to align a primary high density plasma etch of first layer 14.

A photoresist layer 58 is then formed on undoped silicon dioxide layer 54, such that secondary opening 52 is substantially filled, while primary opening 51 remains exposed. The photoresist pattern is such that the alignment with primary opening 51 is not critical. A high density plasma etch of the invention as described above is then applied. In particular, doped silicon dioxide is removed from first layer 14 and contact opening 36 is formed therein as described above in reference to Figure 5. Spacers and undoped silicon dioxide caps of gate stacks 48 are etch stops for the etch process and direct the etch so as to be self-aligning with contact surface 24. In addition, undoped silicon dioxide layer 54 of upper multilayer structure 56 is an etch mask that protects underlying material from the etch process in this embodiment. While a high density plasma etch is preferred, the structure of Figure 6 may be etched using any suitable etching system that is selective to both photoresist layer 58 and to undoped silicon dioxide layer 54 but is not selective to doped silicon dioxide in first layer 14.

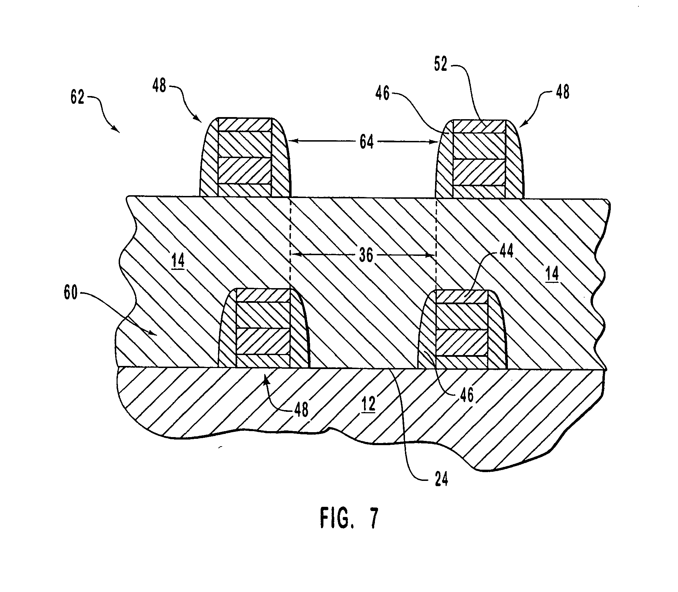

Figure 7 illustrates another method for using a high density plasma etch process for selectively removing doped silicon dioxide, whereby contact openings to a semiconductor substrate are formed. In this embodiment, an upper series of gate stacks 48 are substituted for the etch mask layer 32 of Figure 5. A lower series of substantially parallel gate stacks 48 indicated generally at 60 are formed on semiconductor substrate 12, preferably according to the process disclosed above in reference to gate stacks 48 of Figures 4 and 5. A first layer 14 substantially composed of doped silicon dioxide is positioned on first series 60 and is supported by semiconductor substrate 12. A second series of substantially parallel gate stacks 48 indicated generally at 62 is supported by first layer 14. Again, second series 62 of gate stacks 48 are preferably formed according to the process disclosed above in reference to gate stacks 48 of Figures 4 and 5.

In Figure 7, each gate stack 48 of first series 60 has a longitudinal axis extending into the page that defines a directional component of first series 60. Likewise, each gate stack 48 of second series 62 has a longitudinal axis extending into the page that defines a directional component of second series 62. In the embodiment illustrated in Figure 7, the directional component of first series 60 is substantially parallel to the directional component of second series 62. Alternatively, first and second series 60 and 62 may be aligned in some other manner, including but not limited to being positioned such that the respective directional components thereof are substantially orthogonal with respect to each other.

Gate stacks 48 of second series 62 define a second selected pattern 64 having a series of elongated openings between adjacent gate stacks 48 of second series 62 and substantially parallel thereto. A high density plasma etch as described herein is applied through second selected pattern 64 to form a contact opening 36 as indicated in phantom. Undoped silicon dioxide cap 52 on each gate stack 48 of second series 62 acts as an etch mask, thereby preventing the high density plasma etch from removing material from first layer 14 except as aligned with second selected pattern 64. Spacers 46 of second series 62, whether they are substantially composed of silicon nitride or undoped silicon dioxide, also act as an etch mask. Undoped silicon dioxide caps 44 and spacers 46 of first series 60 act as an etch stop surface, thereby preventing the etching system from substantially removing material from first series 60. The combined function of the etch stop and etch mask structures of Figure 7 provide contact opening 36 that is self-aligned with contact surface 24.

The present methods of the invention have application to a wide variety of structures that are not limited to those used in manufacturing integrated circuits and the like. Any structure containing both undoped and doped silicon dioxide that is susceptible to etching is contemplated by the invention. A high density plasma etch may be applied to such a structure to remove doped silicon dioxide selectively to undoped silicon dioxide to form various types of structures other than those specifically described herein.

## Claims

1. A method for removing doped silicon dioxide, said process comprising:
providing a structure including a first portion (14) substantially composed of doped silicon dioxide and a second portion (16) substantially composed of undoped silicon dioxide, wherein the doped silicon dioxide has a dopant concentration greater than or equal to about 3% by weight and the undoped silicon dioxide has a dopant concentration less than about 3% by weight; and
exposing both of said first portion and said second portion, to a plasma etch process to selectively remove doped silicon dioxide from said first portion at a material removal rate that is greater than the material removal rate of undoped silicon dioxide from said second portion, **characterised in that** the plasma etch process is a high density plasma etch process comprising an ion density of greater than about 10⁹ ions/cm³ and a source power density of less than about 1000 Watts per 200 mm-diameter wafer surface.

2. The method as recited in claim 1, wherein said first portion (14) is in contact with said second portion (16).

3. The method as recited in claim 1, wherein said doped silicon dioxide is removed at a material removal rate that is at least 10 times greater than the material removal rate of said undoped silicon dioxide.

4. The method as recited in claim 1, wherein exposing both of said first portion (14) and said second portion (16) to a high density plasma etch process comprises:
placing said structure within a chamber of a high density plasma chamber (10).

5. The method as recited in claim 1 wherein the high density plasma etch process is conducted using a fluorinated chemical etchant.

6. The method as recited in claim 1, wherein exposing both of said first portion (14) and said second portion (16) to the high density plasma etch process comprises:
placing said structure within a chamber of a high density plasma chamber having an upper electrode (11); and
applying the source power density of less than about 1000 Watts per 200-mm diameter wafer to said upper electrode.

7. The method as recited in claim 1, wherein said structure has a surface with a surface area defined as 0.000245 X m² (X in²), and wherein exposing both of said first portion (14) and said second portion (16) to the high density plasma etch process comprises;
placing said structure within a chamber of a high density plasma chamber having an upper electrode (11) and a lower electrode (13); and
applying a source power to said upper electrode and a bias power to said lower electrode such that the source power density of less than about 1000 Watts (W) per 200 mm-diameter wafer surface is provided to said surface area of said surface of said structure, said bias power being applied in a range of from about 100 Watts less than said source power to about 200 Watts greater than said source power.

8. The method as recited in claim 7, wherein said bias power is applied in a range of from about 100 Watts less than said source power to about 200 Watts greater than said source power.

9. The method as recited in claim 7, wherein said bias power is about equal to said source power.

10. The method as recited claim 1, wherein said material removal rate of said doped silicon dioxide is in a range of from about 500nm/min to about 1000nm/min (about 5,000 Å/min to about 10,000 Å/min).

11. The method as recited in claim 1, wherein exposing both of said first portion (14) and said second portion (16) to the high density plasma etch process comprises:
placing said structure within a chamber of a high density plasma chamber; and
exposing said structure to an etch chemistry including C₂HF₅, CHF₃, and CH₂F₂ at a pressure of less than about 0.67Pa (5 millitorr).

12. The method as recited in claim 1, wherein exposing both of said first portion (14) and said second portion (16) to the high density plasma etch processes comprises:
placing said structure within a chamber of a high density plasma chamber having a lower electrode cooled by a fluid having a temperature in a range from about 0°C to about 40°C.

13. The method as recited in claim 1, wherein said doped silicon dioxide layer is doped with boron at a concentration of at least 3% by weight.

14. The method as recited in claim 1, wherein said doped silicon dioxide layer is doped with phosphorus at a concentration of at least 3% by weight.

15. The method as recited in claim 1, wherein said undoped silicon dioxide layer contacts no more than 3% by weight of boron and contains no more than 3% by weight of phosphorus

16. The method as recited in claim 1, further comprising placing said structure in a chamber of a high density etcher having an upper electrode (11) and lower electrode (13); and
wherein exposing both of said first portion (14) and said second portion (16) to the high density plasma etch process comprises:
applying a source power to the upper electrode (11) of the high density etcher (10) and
applying a bias power to the lower electrode (13) of the high density etcher, said bias power being in a range of from about 200 Watts less than said source power to about 200 Watts greater than said source power, such that said doped silicon dioxide is selectively removed at a material removal rate that is at least 10 times greater than the material removal rate of said undoped silicon dioxide, said material removal rate of said doped silicon dioxide being in a range from about 500nm/min to about 1000nm/min (about 5,000 Å/min to about 10,000 Å/min).

17. The method as recited in claim 1, further comprising placing said structure in a chamber of a high density etcher (10) having a upper electrode (11) and a lower electrode (13); and
wherein exposing both of said first portion (14) and said second portion (16) to the high density plasma etch process comprises:
introducing an etchant selected from the group consisting of C₂F₆, CF₄, C₃F₈, C₄F₁₀, CH₂F₂, CHF₃, C₂HF₅, and CH₃F;
applying a source power to the upper electrode (11) of the high density etcher;
applying a bias power to the lower electrode (13) of the high density etcher, said bias power being in a range of from about 200 Watts less than said source power to about 200 Watts greater than said source power; and
providing the source power density to a surface of said structure, said doped silicon dioxide being selectively removed at a material removal rate that is at least 10 times greater than the material removal rate of said undoped silicon dioxide, said material removal rate of said doped silicon dioxide being in a range from about 500nm/min to about 1000nm/min (about 5,000 Å/min to about 10,000 Å/min).

18. The method as recited in claim 1, wherein providing a structure including a first portion (14) substantially composed of doped silicon dioxide and a second portion (16) substantially composed of undoped silicon dioxide comprises:
forming a first layer supported by a substrate, said first layer being said first portion;
forming a second layer supported by said first layer, said second layer being said second portion; and
forming an opening through said second portion to expose a surface on said first portion; and
wherein exposing both of said first portion (14) and said second portion (16) to the high density plasma etch process comprises:
conducting the high density plasma etch on both of said first portion and said second portion to selectively remove doped silicon dioxide from said first portion through said opening at a material removal rate that is greater than the material removal rate of undoped silicon dioxide from said second portion.

19. The method as recited in claim 18, wherein said high density plasma etch process comprises etching said doped silicon dioxide with an etchant selected from the group consisting of C₂F₆, CF₄, C₃F₈, C₄F₁₀, CH₂F₂, CHF₃, C₂HF₅, and CH₃F.

20. The method as recited in claim 18, further comprising forming at least one interleaving layer positioned between said first portion (14) and said second portion (16).

21. The method as recited in claim 20, wherein said at least one interleaving layer is substantially composed of at least one material selected from a group consisting of silicides of molybdenum, chromium, tungsten, titanium, tantalum, platinum and zirconium.

22. The method as recited in claim 20, wherein said at least one interleaving layer is substantially composed of polysilicon.

23. The method as recited in claim 18, wherein conducting said high density plasma etch comprises exposing a surface on a substrate on which the first portion (14) and the second portion (16) are present.

24. The method as recited in claim 18, further comprising forming an etch stop layer before forming said first portion, said etch stop layer being supported by said substrate and substantially composed of undoped silicon dioxide, a portion of said etch stop layer being exposed by conducting said high density plasma etch.

25. The method as recited in claim 20, wherein said at least one interleaving layer comprises;
a polysilicon layer; and
a refractory metal silicide layer.

26. The method as recited in claim 25, wherein said refractory metal silicide layer is substantially composed of tungsten silicide.

27. The method as recited in claim 1, wherein providing a structure including a first portion (14) substantially composed of doped silicon dioxide and a second portion (16) substantially composed of undoped silicon dioxide comprises:
forming a first layer on a semiconductor substrate, said first layer being said fust portion;
forming a second layer supported by said first portion, said second layer being said second portion;
providing a pattern extending through said second portion, a portion of said first portion under said pattern being exposed;
and wherein exposing both of said first portion and said second portion to the high density plasma etch process comprises:
conducting the high density plasma etch on both of said first portion and said second portion, the source power density being applied to both of said first portion and said second portion to selectively remove doped silicon dioxide from said first portion through said pattern to form an opening in said first portion, said opening being defined by an exposed contact surface on said semiconductor substrate and a sidewall substantially orthogonal to said exposed contact surface.

28. The method as recited in claim 27, further comprising a contact plug substantially composed of a conductive material on said exposed surface within said opening.

29. The method as recited in claim 1, wherein providing a structure including a first portion substantially composed of doped silicon dioxide and a second portion substantially composed of undoped silicon dioxide comprises:
providing a multilayer structure having:
a first layer (14) supported by a substrate, said first layer being said first portion; and
a second layer (16) supported by said first layer, said second layer being said second portion;
forming a primary opening and a secondary opening in said second portion, said primary opening and said secondary opening extending to said first portion;
forming a photoresist layer over said second portion, said photoresist layer at least partially filling said secondary opening and substantially not filling said primary opening; and
wherein exposing both of said first portion and said second portion to the high density plasma etch process comprises:
conducting the high density plasma etch on both of said first portion and said second portion through said primary opening, the source power density being applied to both of said first portion and said second portion, said doped silicon dioxide being selectively removed from said first portion through said primary opening at a material removal rate that is greater than the material removal rates of undoped silicon dioxide from said second portion and photoresist material from said photoresist layer;

30. The method as recited in claim 1, wherein providing a structure including a first portion (14) substantially composed of doped silicon dioxide and a second portion (16) substantially composed ofundoped silicon dioxide comprises:
forming a first series of gate stacks supported by a substrate;
forming the first portion as a first layer over said first series of gate stacks;
forming a second series of gate stacks supported by said first portion, said second series defining at least one space between any two adjacent gate stacks of said second series, each said gate stack of said second series including:
an undoped silicon dioxide layer constituting said second portion which defines a upper surface on each said gate stack of said second series; and
a spacer in contact with said undoped silicon dioxide layer, said spacer defining a lateral surface on each said gate stack of said second series; and wherein exposing both of said first portion and said second portion to the high density plasma etch process comprises:
conducting the high density plasma etch on both of said first portion and said second portion, the source power density being applied to both of said first portion and said second portion to selectively remove doped silicon dioxide from said first portion through at least one opening at a material removal rate that is greater than the material removal rate of undoped silicon dioxide from said second portion.

31. The method as recited in claim 30, wherein said spacer is substantially composed of undoped silicon dioxide and doped silicon dioxide is selectively removed from said doped silicon dioxide at a material removal rate that is greater than the material removal rate of undoped silicon dioxide from said spacer.

32. The method as recited in claim 30, wherein said gate stacks of said first series are positioned parallel one with another, said first series defining a first directional component; and
said gate stacks of said second series are positioned parallel one with another, said second series defining a second directional component.

33. The method as recited in claim 32, wherein said first directional component is substantially parallel to said second directional component.

34. The method as recited in claim 32, wherein said first directional component is substantially orthogonal to said second directional component.

35. The method as recited in claim 30, wherein each said gate stack of said first series comprises:
a gate oxide layer supported by said substrate;
a polysilicon layer on said gate oxide layer;
a refractory metal silicide layer on said polysilicon layer;
an undoped silicon dioxide layer on said refractory metal silicide layer; and
a spacer substantially composed of undoped silicon dioxide, said spacer being in contact with said gate oxide layer, said polysilicon layer, said refractory metal silicide layer, and said undoped silicon dioxide layer.

36. The method as recited in claim 35, wherein said refractory metal silicide layer of each said gate stack is substantially composed of tungsten silicide.

37. The method as recited in claim 1, wherein providing a structure including a first portion (14) substantially composed of doped silicon dioxide and a second portion (16) substantially composed of undoped silicon dioxide comprises:
forming the second portion as a layer over a semiconductor substrate;
forming the first portion as a layer over said second portion; and wherein exposing both of said first portion and said second portion to the high density plasma etch process comprises:
conducting the high density plasma etch on both of said first portion and said second portion, the source power density being applied to both of said first portion and said second portion said doped silicon dioxide being selectively removed from said first portion to expose a portion of said second portion, said doped silicon dioxide being removed at a material removal rate greater than the material removal rate of undoped silicon dioxide from said second layer.

38. The method as recited in claim 37, further comprising:
forming a photoresist layer over said first portion (14):
providing a pattern in said photoresist layer; and
conducting said high density plasma etch to remove said doped silicon dioxide through said pattern in said photoresist layer.

39. The method as recited in claim 37, wherein a surface of said semiconductor substrate is exposed upon conducting said high density plasma etch, said material removal rate of said doped silicon dioxide being at least 10 times greater than the material removal rate of a semiconductor material from said semiconductor substrate.

40. The method as recited in claim 37, wherein said semiconductive material is substantially composed of monocrystalline silicon.

41. The method as recited in claim 37, wherein said high density plasma etch is conducted at an operating pressure in a range of from about 133mPa to about 1.33Pa (about 1 millitorr to about 10 millitorr).

42. The method as recited in claim 1, wherein providing a structure including a first portion (14) substantially composed of doped silicon dioxide and a second portion (16) substantially composed of undoped silicon dioxide comprises:
providing a gate oxide layer over a semiconductor substrate composed of a semiconductor material;
providing a pair of gate stacks in spaced relation to one another on said gate oxide layer, each of said gate stacks having at least one conductive layer formed therein and the second portion of undoped silicon dioxide extending over said conductive layer, a contact surface on said semiconductor substrate being positioned between said pair of gate stacks;
forming a spacer composed of a spacer material adjacent to each of said gate stacks;
forming the first portion of doped silicon dioxide as a layer over said pair of gate stacks and over said contact surface; and
wherein exposing both of said first portion and said second portion to the high density plasma etch process comprises conducting the high density plasma etch wherein the source power density is applied to both of said first portion and said second portion to form a contact opening extending to said contact surface, said doped silicon dioxide being removed at a material removal rate that is at least 10 times greater than the material removal rates for each of undoped silicon dioxide from said second portion said spacer material from said spacer, and said semiconductor material from said semiconductor substrate.

43. The method as recited in claim 42, wherein:
said at least one conductive layer comprises a polysilicon layer formed over said gate oxide layer; and
each said gate stack further comprise a refractory metal silicide layer formed over said at least one conductive layer and under said undoped silicon dioxide.

44. The method as recited in claim 43, wherein providing said pair of gate stacks further comprises selectively removing portions of said undoped silicon dioxide, said refractory metal silicide layer, said polysilicon layer, and said gate oxide layer.

45. The method as recited in claim 42, wherein said gate stack comprises;
said substantially undoped silicon dioxide as a top layer thereof;
a refractory metal silicide layer;
a polysilicon layer; and
a gate oxide layer as a bottom layer thereof.

46. The method as recited in claim 42, wherein said spacer material is substantially composed of silicon nitride.

47. The method as recited in claim 42, wherein the spacer material is substantially composed of undoped silicon dioxide.

48. The method as recited in claim 42, further comprising forming a contact plug substantially composed of a conductive material, said contact plug being formed between said pair of gate stacks and on said contact surface.

49. The method as recited in claim 1, wherein providing a structure including a first portion (14) substantially composed of doped silicon dioxide and a second portion (16) substantially composed of undoped silicon dioxide comprises:
providing a semiconductor substrate;
providing a multilayer structure over said semiconductor substrate;
depositing the second portion as a layer over said multilayer structure using a precursor having a gaseous silane, hydrogen, and oxygen flow;
forming a first photoresist layer over said second portion;
patterning said first photoresist layer to form a first selected pattern;
etching said second portion and said multilayer structure through said first selected pattern to expose a contact surface on said semiconductor substrate;
removing said first photoresist layer;
depositing a layer of a nonconductive material over both of said second portion and said contact surface;
etching said layer of non-conductive material to form a spacer over a lateral side of said second portion and over a lateral side of said multilayer structure, said spacer being generally perpendicular to said semiconductor substrate;
depositing the first portion over both of said multilayer structure and said second portion;
forming a second photoresist layer over said first portion; and
patterning said second photoresist layer to form a second selected pattern material from said spacer; and
wherein exposing both of said first portion and said second portion to the high density plasma etch process comprises conducting the high density plasma etch wherein the source power density is applied to both of said first portion and said second portion, doped silicon dioxide being selectively removed from said first portion through said second selected pattern to expose said contact surface, said doped silicon dioxide being removed at a material removal rate that is at least 10 times greater than the material removal rates for each of undoped silicon dioxide from said second portion, nonconductive material from said spacer, semiconductive material from said semiconductor substrate, and photoresist material from said second photoresist layer; and
further comprising removing said second photoresist layer and forming a contact plug substantially composed of a conductive material in contact with said contact surface.

50. The method as recited in claim 49, wherein said nonconductive material is one of silicon nitride and substantially undoped silicon dioxide.

51. The method as recited in claim 1, wherein said multilayer structure comprises successive layers of gate oxide, polysilicon, and refractory metal silicide.

52. The method as recited in claim 1, wherein providing a structure including a first portion (14) substantially composed of doped silicon dioxide and a second portion (16) substantially composed of undoped silicon dioxide comprises:
providing a multilayer structure over a semiconductor substrate, said multilayer structure comprising successive layers of gate oxide, polysilicon, and refractory metal silicide;
depositing the second portion as a layer over said multilayer structure using a precursor having a gaseous silane, hydrogen, and oxygen flow;
forming a first photoresist layer over said second portion;
patterning said first photoresist layer to form a first selected pattern;
etching said second portion and said multilayer structure through said first selected pattern to expose a contact surface on said semiconductor substrate;
removing said first photoresist layer;
forming a layer of a nonconductive material over both of said second portion and said contact surface;
etching said layer of said nonconductive material to form a spacer over a lateral side of said second portion and over a lateral side of said multilayer structure, said spacer being generally perpendicular to said semiconductor substrate;
forming the first portion as a layer over both of said multilayer structure and said contact surface;
forming a second photoresist layer over said first portion;
patterning said second photoresist layer to form a second selected pattern material from said spacer; and
wherein exposing both of said first and said second portion to the high density plasma etch process comprises conducting the high density plasma etch wherein a source power density is applied to both of said first portion and said second portion, doped silicon dioxide being selectively removed from said first portion through said second selected pattern to expose said contact surface, said doped silicon dioxide being removed at a material removal rate that is at least 10 times greater than the material removal rates for each of undoped silicon dioxide from said second portion, nonconductive material from said spacer, semiconductive material from said semiconductor substrate, and photoresist material from said second photoresist layer; and
further comprising removing said second photoresist layer and forming a contact plus substantially composed of a conductive material in contact with said contact surface.

53. The method as recited in claim 1, wherein providing a structure including a first portion (14) substantially composed of doped silicon dioxide and a second portion (16) substantially composed of undoped silicon dioxide comprises;
providing a semiconductor substrate;
providing a pair of gate stacks in spaced relation to one another on said semiconductor substrate, each of said gate stacks being covered by an undoped silicon dioxide layer constituting said second portion;
forming a spacer adjacent to each of said gate stacks;
forming said first portion as a layer over said pair of gate stacks and over said semiconductor substrate;
forming a photoresist layer over said first portion; and
providing a pattern in said photoresist layer; and
wherein exposing both of said first portion and said second portion to the high density plasma etch process comprises conducting the high density plasma etch wherein a source power density is applied to both of said first portion and said second portion, doped silicon dioxide being selectively removed from said doped silicon dioxide layer between said pair of gate stacks and through said pattern to form a self-aligned contact opening extending to said contact surface, doped silicon dioxide being removed at a substantially greater material removal rate than that of undoped silicon dioxide from said undoped silicon dioxide layer, said undoped silicon layer substantially resisting said high density plasma etch.

## Patentansprüche

1. Verfahren zur Entfernung von dotiertem Siliciumdioxid, wobei das Verfahren umfasst:
Bereitstellen einer Struktur, einschließend einen ersten Bereich (14), der im Wesentlichen aus dotiertem Silicumdioxid besteht, und einen zweiten Bereich (16), der im Wesentlichen aus undotiertem Siliciumdioxid besteht, wobei das dotierte Siliciumdioxid eine Dotierungsmittelkonzentration von größer als oder gleich etwa 3 Gewichtsprozent hat und das undotierte Siliciumdioxid eine Dotierungsmittelkonzentration von kleiner als etwa 3 Gewichtsprozent hat; und
Aussetzen sowohl des ersten Bereichs als auch des zweiten Bereichs einem Plasmaätzverfahren, um dotiertes Siliciumdioxid selektiv aus dem ersten Bereich mit einer Materialentfernungsrate, die größer ist als die Materialentfernungsrate für undotiertes Siliciumdioxid, aus dem zweiten Bereich zu entfernen, **dadurch gekennzeichnet, dass** das Plasmaätzverfahren ein Ätzverfahren mit Plasma hoher Dichte ist, das eine Ionendichte von größer als etwa 10⁹ Ionen/cm³ und eine Ausgangsleistungsdichte von kleiner als etwa 1.000 Watt pro Waferoberfläche mit einem Durchmesser von 200 mm umfasst.

2. Verfahren gemäß Anspruch 1, wobei der erste Bereich (14) mit dem zweiten Bereich (16) in Kontakt ist.

3. Verfahren gemäß Anspruch 1, wobei das dotierte Siliciumdioxid mit einer Materialentfernungsrate entfernt wird, die wenigstens 10-mal größer ist als die Materialentfernungsrate für das undotierte Siliciumdioxid.

4. Verfahren gemäß Anspruch 1, wobei ein Aussetzen sowohl des ersten Bereichs (14) als auch des zweiten Bereichs (16) einem Ätzverfahren mit Plasma hoher Dichte umfasst:
Platzieren der Struktur in einer Kammer einer Kammer mit Plasma hoher Dichte (10).

5. Verfahren gemäß Anspruch 1, wobei das Ätzverfahren mit Plasma hoher Dichte unter Verwendung eines fluorierten chemischen Ätzmittels durchgeführt wird.

6. Verfahren gemäß Anspruch 1, wobei das Aussetzen sowohl des ersten Bereichs (14) als auch des zweiten Bereichs (16) einem Ätzverfahren mit Plasma hoher Dichte umfasst:
Platzieren der Struktur in einer Kammer einer Kammer mit Plasma hoher Dichte, die eine obere Elektrode (11) hat; und
Anlegen einer Ausgangsleistungsdichte (source power density) von kleiner als etwa 1.000 Watt pro Waferoberfläche mit einem Durchmesser von 200 mm an die obere Elektrode.

7. Verfahren gemäß Anspruch 1, wobei die Struktur eine Oberfläche mit einem Oberflächenbereich, definiert als 0,000245 X m² (X in²), hat und wobei das Aussetzen sowohl des ersten Bereichs (14) als auch des zweiten Bereichs (16) einem Ätzverfahren mit Plasma hoher Dichte umfasst:
Platzieren der Struktur in einer Kammer einer Kammer mit Plasma hoher Dichte, die eine obere Elektrode (11) und eine untere Elektrode (13) hat; und
Anlegen einer Ausgangsleistung bzw. einer Spannung (source power) an die obere Elektrode und einer Vorleistung (bias power) an die untere Elektrode, so dass die Ausgangsleistungsdichte von kleiner als 1.000 Watt (W) pro 200 mm Durchmesser der Waferoberfläche auf dem Oberflächenbereich der Oberfläche der Struktur bereitgestellt wird, wobei die Vorleistung in einem Bereich von etwa 100 Watt kleiner als die Ausgangsleistung bis etwa 200 Watt größer als die Ausgangsleistung angelegt bzw. angewendet wird.

8. Verfahren gemäß Anspruch 7, wobei die Vorleistung (bias power) in einem Bereich von etwa 100 Watt kleiner als die Ausgangsleistung bis etwa 200 Watt größer als die Ausgangsleistung angelegt bzw. angewendet wird.

9. Verfahren gemäß Anspruch 7, wobei die Vorleistung (bias power) etwa gleich der Ausgangsleistung ist.

10. Verfahren gemäß Anspruch 1, wobei die Materialentfernungsrate für das dotierte Siliciumdioxid in einem Bereich von etwa 500 nm/min bis etwa 1.000 nm/min (etwa 5.000 Ä/min bis etwa 10.000 Å/min) ist.

11. Verfahren gemäß Anspruch 1, wobei das Aussetzen sowohl des ersten Bereichs (14) als auch des zweiten Bereichs (16) dem Ätzverfahren mit Plasma hoher Dichte umfasst:
Platzieren der Struktur in einer Kammer einer Kammer mit Plasma hoher Dichte und
Aussetzen der Struktur einer Ätzchemie, die C₂HF₅, CHF₃ und CH₂F₂ bei einem Druck von weniger als etwa 0,67 Pa (5 Millitorr).

12. Verfahren gemäß Anspruch 1, wobei das Aussetzen sowohl des ersten Bereichs (14) als auch des zweiten Bereichs (16) den Ätzverfahren mit Plasma hoher Dichte umfasst:
Platzieren der Struktur in einer Kammer einer Kammer mit Plasma hoher Dichte, die eine untere Elektrode hat, die durch ein Fluid gekühlt wird, das eine Temperatur in einem Bereich von etwa 0°C bis etwa 40°C hat.

13. Verfahren gemäß Anspruch 1, wobei die dotierte Siliciumdioxidschicht mit Bor mit einer Konzentration von wenigstens 3 Gewichtsprozent dotiert ist.

14. Verfahren gemäß Anspruch 1, wobei die dotierte Siliciumdioxidschicht mit Phosphor mit einer Konzentration von wenigstens 3 Gewichtsprozent dotiert ist.

15. Verfahren gemäß Anspruch 1, wobei die undotierte Siliciumdioxidschicht nicht mehr als 3 Gewichtsprozent Bor berührt und nicht mehr als 3 Gewichtsprozent Phosphor enthält.

16. Verfahren gemäß Anspruch 1, außerdem umfassend Platzieren der Struktur in einer Kammer eines Ätzers mit hoher Dichte, der eine obere Elektrode (11) und eine untere Elektrode (13) hat; und
wobei das Aussetzen sowohl des ersten Bereichs (14) als auch des zweiten Bereichs (16) dem Ätzverfahren mit Plasma hoher Dichte umfasst:
Anlegen einer Ausgangsleistung (source power) an die obere Elektrode (11) des Ätzers mit hoher Dichte (10) und
Anlegen einer Vorleistung an die untere Elektrode (13) des Ätzers mit hoher Dichte, wobei die Vorleistung in einem Bereich von etwa 200 Watt kleiner als die Ausgangsleistung bis etwa 200 Watt größer als die Ausgangsleistung liegt, so dass das dotierte Siliciumdioxid selektiv mit einer Materialentfernungsrate entfernt wird, die wenigstens 10-mal größer als die Materialentfernungsrate für das undotierte Siliciumdioxid ist, wobei die Materialentfernungsrate für das dotierte Siliciumdioxid in einem Bereich von etwa 500 nm/min bis etwa 1.000 nm/min (etwa 5.000 Å/min bis etwa 10.000 Å/min) liegt.

17. Verfahren gemäß Anspruch 1, außerdem umfassend Platzieren der Struktur in einer Kammer eines Ätzers mit hoher Dichte (10), der eine obere Elektrode (11) und eine untere Elektrode (13) hat; und
wobei das Aussetzen sowohl des ersten Bereichs (14) als auch des zweiten Bereichs (16) dem Ätzverfahren mit Plasma hoher Dichte umfasst:
Einführen eines Ätzmittels, ausgewählt aus der Gruppe, bestehend aus C₂F₆, CF₄, C₃F₈, C₄F₁₀, CH₂F₂, CHF₃, C₂HF₅ und CH₃F;
Anlegen einer Ausgangsleistung an die obere Elektrode (11) des Ätzers mit hoher Dichte;
Anlegen einer Vorleistung an die untere Elektrode (13) des Ätzers mit hoher Dichte, wobei die Vorleistung in einem Bereich von etwa 200 Watt kleiner als die Ausgangsleistung bis etwa 200 Watt größer als die Ausgangsleistung liegt; und
Bereitstellen einer Ausgangsleistungsdichte für die Oberfläche der Struktur, wobei das dotierte Siliciumdioxid bei einer Materialentfernungsrate, die wenigstens 10-mal größer ist als die Materialentfernungsrate für das undotierte Siliciumdioxid, selektiv entfernt wird, wobei die Materialentfernungsrate für das dotierte Siliciumdioxid in einem Bereich von etwa 500 nm/min bis etwa 1.000 nm/min (etwa 5.000 Å/min bis etwa 10.000 Å/min) ist.

18. Verfahren gemäß Anspruch 1, wobei ein Bereitstellen einer Struktur, einschließend einen ersten Bereich (14), der im Wesentlichen aus dotiertem Siliciumdioxid besteht, und einen zweiten Bereich (16), der im Wesentlichen aus undotiertem Siliciumdioxid besteht, umfasst:
Bilden einer ersten Schicht, die von einem Substrat getragen wird, wobei die erste Schicht der erste Bereich ist;
Bilden einer zweiten Schicht, die von der ersten Schicht getragen wird, wobei die zweite Schicht der zweite Bereich ist; und
Bilden einer Öffnung durch den zweiten Bereich, um eine Oberfläche an dem ersten Bereich freizulegen; und
wobei ein Aussetzen sowohl des ersten Bereichs (14) als auch des zweiten Bereichs (16) dem Ätzverfahren mit Plasma hoher Dichte umfasst:
Durchführen des Ätzens mit Plasma hoher Dichte an sowohl dem ersten Bereich als auch dem zweiten Bereich, um dotiertes Siliciumdioxid selektiv aus dem ersten Bereich durch die Öffnung mit einer Materialentfernungsrate zu entfernen, die größer ist als die Materialentfernungsrate für undotiertes Siliciumdioxid aus dem zweiten Bereich.

19. Verfahren gemäß Anspruch 18, wobei das Ätzverfahren mit Plasma hoher Dichte ein Ätzen des dotierten Siliciumdioxids mit einem Ätzmittel, ausgewählt aus der Gruppe, bestehend aus C₂F₆, CF₄, C₃F₈, C₄F₁₀, CH₂F₂, CHF₃, C₂HF₅ und CH₃F umfasst.

20. Verfahren gemäß Anspruch 18, das außerdem ein Bilden wenigstens einer Interleave-Schicht, die zwischen dem ersten Bereich (14) und dem zweiten Bereich (16) angeordnet ist, umfasst.

21. Verfahren gemäß Anspruch 20, wobei die wenigstens eine Interleave-Schicht im Wesentlichen aus wenigstens einem Material besteht, das aus einer Gruppe, bestehend aus Siliciden von Molybdän, Chrom, Wolfram, Titan, Tantal, Platin und Zirkonium, ausgewählt wird.

22. Verfahren gemäß Anspruch 20, wobei die wenigstens eine Interleave-Schicht im Wesentlichen aus Polysilicium besteht.

23. Verfahren gemäß Anspruch 18, wobei ein Durchführen des Ätzens mit Plasma hoher Dichte Freilegen einer Oberfläche auf einem Substrat, auf dem der erste Bereich (14) und der zweite Bereich (16) vorliegen, umfasst.

24. Verfahren gemäß Anspruch 18, außerdem umfassend Bilden einer Ätzstoppschicht vor Bilden des ersten Bereichs, wobei die Ätzstoppschicht von dem Substrat getragen wird und im Wesentlichen aus undotiertem Siliciumdioxid besteht, wobei ein Bereich der Ätzstoppschicht durch Durchführen des Ätzens mit Plasma hoher Dichte freigelegt wird.

25. Verfahren gemäß Anspruch 20, wobei die wenigstens eine Interleave-Schicht umfasst:
eine Polysiliciumschicht und
eine feuerfeste Metallsilicidschicht.

26. Verfahren gemäß Anspruch 25, wobei die feuerfeste Metallsilicidschicht im Wesentlichen aus Wolframsilicid besteht.

27. Verfahren gemäß Anspruch 1, wobei ein Bereitstellen einer Struktur, einschließend einen ersten Bereich (14), der im Wesentlichen aus dotiertem Siliciumdioxid besteht, und einen zweiten Bereich (16), der im Wesentlichen aus undotiertem Siliciumdioxid besteht, umfasst:
Bilden einer ersten Schicht auf einem Halbleitersubstrat, wobei die erste Schicht der erste Bereich ist;
Bilden einer zweiten Schicht, die von dem ersten Bereich getragen wird, wobei die zweite Schicht der zweite Bereich ist;
Bereitstellen eines Musters, das sich durch den zweiten Bereich erstreckt, wobei ein Teil des ersten Bereichs unter dem Muster freigelegt wird;
und wobei ein Aussetzen sowohl des ersten Bereichs als auch des zweiten Bereichs einem Ätzverfahren mit Plasma hoher Dichte umfasst:
Durchführen des Ätzens mit Plasma hoher Dichte an sowohl dem ersten Bereich als auch dem zweiten Bereich, wobei die Ausgangsleistungsdichte sowohl auf den ersten Bereich als auch auf den zweiten Bereich angewendet wird, um dotiertes Siliciumdioxid selektiv aus dem ersten Bereich durch das Muster zu entfernen, um eine Öffnung in dem ersten Bereich zu bilden, wobei die Öffnung durch eine freigelegte Kontaktoberfläche auf dem Halbleitersubstrat und eine Seitenwand, die im Wesentlichen orthogonal zu der freigelegten Kontaktoberfläche ist, definiert wird.

28. Verfahren gemäß Anspruch 27, das außerdem einen Kontaktstöpsel, der im Wesentlichen aus einem leitfähigen Material besteht, an der freigelegten Oberfläche innerhalb der Öffnung umfasst.

29. Verfahren gemäß Anspruch 1, wobei ein Bereitstellen einer Struktur, einschließend einen ersten Bereich, der im Wesentlichen aus dotiertem Siliciumdioxid besteht, und einen zweiten Bereich, der im Wesentlichen aus undotiertem Siliciumdioxid besteht, umfasst:
Bereitstellen einer Mehrschichtstruktur, die aufweist:
eine erste Schicht (14), die durch ein Substrat getragen wird, wobei die erste Schicht der erste Bereich ist; und
eine zweite Schicht (16), die von der ersten Schicht getragen wird, wobei die zweite Schicht der zweite Bereich ist;
Bilden einer ersten Öffnung und einer zweiten Öffnung in dem zweiten Bereich, wobei die erste Öffnung und die zweite Öffnung sich zu dem ersten Bereich erstrecken;
Bilden einer Photoresistschicht über dem zweiten Bereich, wobei die Photoresistschicht wenigstens teilweise die zweite Öffnung füllt und die erste Öffnung im Wesentlichen nicht füllt; und
wobei ein Aussetzen sowohl des ersten Bereichs als auch des zweiten Bereichs dem Ätzverfahren mit Plasma hoher Dichte umfasst:
Durchführen des Ätzens mit Plasma hoher Dichte sowohl an dem ersten Bereich als auch an dem zweiten Bereich durch die erste Öffnung, wobei die Ausgangsleistungsdichte sowohl auf den ersten Bereich als auch auf den zweiten Bereich angewendet wird, wobei dotiertes Siliciumdioxid selektiv aus dem ersten Bereich durch die erste Öffnung mit einer Materialentfernungsrate entfernt wird, die größer ist als die Materialentfernungsraten für undotiertes Siliciumdioxid aus dem zweiten Bereich und für Photoresistmaterial aus der Photoresistschicht.

30. Verfahren gemäß Anspruch 1, wobei Bereitstellen einer Struktur, einschließend einen ersten Bereich (14), der im Wesentlichen aus dotiertem Siliciumdioxid besteht, und einem zweiten Bereich (16), der im Wesentlichen aus undotiertem Siliciumdioxid besteht, umfasst:
Bilden einer ersten Reihe von Gate-Stapeln, die durch ein Substrat getragen werden;
Bilden des ersten Bereichs als eine erste Schicht über der ersten Reihe von Gate-Stapeln;
Bilden einer zweiten Reihe von Gate-Stapeln, die von dem ersten Bereich getragen wird, wobei die zweite Reihe einen Raum zwischen beliebigen zwei benachbarten Gate-Stapeln der zweiten Reihe definiert, wobei jeder Gate-Stapel der zweiten Reihe umfasst:
eine undotierte Siliciumdioxidschicht, die den zweiten Bereich bildet, die eine obere Oberfläche an jedem Gate-Stapel der zweiten Reihe definiert; und
einen Abstandhalter in Kontakt mit der undotierten Siliciumdioxidschicht, wobei der Abstandhalter eine laterale Oberfläche an jedem Gate-Stapel der zweiten Reihe definiert; und
wobei ein Aussetzen sowohl des ersten Bereichs als auch des zweiten Bereichs dem Ätzverfahren mit Plasma hoher Dichte umfasst:
Durchführen des Ätzens mit Plasma hoher Dichte an sowohl dem ersten Bereich als auch dem zweiten Bereich, wobei die Ausgangsleistungsdichte sowohl auf den ersten Bereich als auch auf den zweiten Bereich angewendet wird, um dotiertes Siliciumdioxid aus dem ersten Bereich durch wenigstens eine Öffnung mit einer Materialentfernungsrate selektiv zu entfernen, die größer ist als die Materialentfernungsrate für undotiertes Siliciumdioxid aus dem zweiten Bereich.

31. Verfahren gemäß Anspruch 30, wobei der Abstandhalter im Wesentlichen aus undotiertem Siliciumdioxid besteht und dotiertes Siliciumdioxid selektiv von dem dotierten Siliciumdioxid mit einer Materialentfernungsrate entfernt wird, die größer ist als die Materialentfernungsrate für undotiertes Siliciumdioxid aus dem Abstandhalter.

32. Verfahren gemäß Anspruch 30, wobei die Gate-Stapel der ersten Reihe parallel zueinander angeordnet sind, wobei die erste Reihe eine erste direktionale Komponente definiert; und
die Gate-Stapel der zweiten Reihe parallel zueinander angeordnet sind, wobei die zweite Reihe eine zweite direktionale Komponente definiert.

33. Verfahren gemäß Anspruch 32, wobei die erste direktionale Komponente im Wesentlichen parallel zu der zweiten direktionalen Komponente ist.

34. Verfahren gemäß Anspruch 32, wobei die erste direktionale Komponente im Wesentlichen orthogonal zu der zweiten direktionalen Komponente ist.

35. Verfahren gemäß Anspruch 30, wobei jeder Gate-Stapel der ersten Reihe umfasst:
eine Gate-Oxidschicht, die durch das Substrat getragen wird;
eine Polysiliciumschicht auf der Gate-Oxidschicht;
eine feuerfeste Metallsilicidschicht auf der Polysiliciumschicht;
eine undotierte Siliciumdioxidschicht auf der feuerfesten Metallsilicidschicht und
einen Abstandhalter, der im Wesentlichen aus undotiertem Siliciumdioxid besteht, wobei der Abstandhalter in Kontakt mit der Gate-Oxidschicht, der Polysiliciumschicht, der feuerfesten Metallsilicidschicht und der undotierten Siliciumdioxidschicht ist.

36. Verfahren gemäß Anspruch 35, wobei die feuerfeste Metallsilicidschicht jedes Gate-Stapels im Wesentlichen aus Wolframsilicid besteht.

37. Verfahren gemäß Anspruch 1, wobei Bereitstellen einer Struktur, einschließend einen ersten Bereich (14), der im Wesentlichen aus dotiertem Siliciumdioxid besteht, und einen zweiten Bereich (16), der im Wesentlichen aus undotiertem Siliciumdioxid besteht, umfasst:
Bilden des zweiten Bereichs als eine Schicht über einem Halbleitersubstrat;
Bilden des ersten Bereichs als eine Schicht über dem zweiten Bereich und
wobei das Aussetzen sowohl des ersten Bereichs als auch des zweiten Bereichs dem Ätzverfahren mit Plasma hoher Dichte umfasst:
Durchführen des Ätzens mit Plasma hoher Dichte an sowohl dem ersten Bereich als auch dem zweiten Bereich, wobei die Ausgangsleistungsdichte sowohl auf den ersten Bereich als auch den zweiten Bereich angewendet wird, wobei das dotierte Siliciumdioxid selektiv aus dem ersten Bereich entfernt wird, um einen Teil des zweiten Bereichs freizulegen, wobei das dotierte Siliciumdioxid mit einer Materialentfernungsrate entfernt wird, die größer ist als die Materialentfernungsrate für undotiertes Siliciumdioxid aus der zweiten Schicht.

38. Verfahren gemäß Anspruch 37, außerdem umfassend:
Bilden einer Photoresistschicht über dem ersten Bereich (14);
Bereitstellen eines Musters in der Photoresistschicht und
Durchführen des Ätzens mit Plasma hoher Dichte, um das dotierte Siliciumdioxid durch das Muster in der Photoresistschicht zu entfernen.

39. Verfahren gemäß Anspruch 37, wobei eine Oberfläche des Halbleitersubstrats bei Durchführen des Ätzens mit Plasma hoher Dichte freigelegt wird, wobei die Materialentfernungsrate für das dotierte Siliciumdioxid wenigstens 10-mal größer ist als die Materialentfernungsrate für ein Halbleitermaterial aus dem Halbleitersubstrat.

40. Verfahren gemäß Anspruch 37, wobei das halbleitende Material im Wesentlichen aus monokristallinem Silicium besteht.

41. Verfahren gemäß Anspruch 37, wobei das Ätzen mit Plasma hoher Dichte bei einem Arbeitsdruck in einem Bereich von etwa 133 mPa bis etwa 1,33 Pa (etwa 1 Millitorr bis etwa 10 Millitorr) durchgeführt wird.

42. Verfahren gemäß Anspruch 1, wobei Bereitstellen einer Struktur, einschließend einen ersten Bereich (14), der im Wesentlichen aus dotiertem Siliciumdioxid besteht, und einem zweiten Bereich (16), der im Wesentlichen aus undotiertem Siliciumdioxid besteht, umfasst:
Bereitstellen einer Gate-Oxidschicht über einem Halbleitersubstrat, das aus einem Halbleitermaterial besteht;
Bereitstellen eines Paars von Gate-Stapeln in beabstandeter Beziehung zueinander auf der Gate-Oxidschicht, wobei jeder der Gate-Stapel wenigstens eine leitende Schicht darauf gebildet hat und sich der zweite Bereich aus undotiertem Siliciumdioxid über die leitende Schicht erstreckt, eine Kontaktoberfläche auf dem Halbleitersubstrat zwischen dem Paar von Gate-Stapeln angeordnet ist;
Bilden eines Abstandhalters, der aus einem Abstandhaltermaterial besteht, angrenzend an jeden der Gate-Stapel;
Bilden des ersten Bereichs aus dotiertem Siliciumdioxid als eine Schicht über dem Paar von Gate-Stapeln und über der Kontaktoberfläche und
wobei ein Aussetzen sowohl des ersten Bereichs als auch des zweiten Bereichs dem Ätzverfahren mit Plasma hoher Dichte ein Durchführen des Ätzens mit Plasma hoher Dichte umfasst, wobei die Ausgangsleistungsdichte sowohl auf den ersten Bereich als auch den zweiten Bereich angewendet wird, um eine Kontaktöffnung zu bilden, die sich zu der Kontaktoberfläche erstreckt, wobei das dotierte Siliciumdioxid mit einer Materialentfernungsrate entfernt wird, die wenigstens 10-mal größer ist als die Materialentfernungsraten für jedes von undotiertem Siliciumdioxid aus dem zweiten Bereich, dem Abstandhaltermaterial aus dem Abstandhalter und dem Halbleitermaterial aus dem Halbleitersubstrat.

43. Verfahren gemäß Anspruch 42, wobei:
die wenigstens eine leitende Schicht eine Polysiliciumschicht umfasst, die über der Gate-Oxidschicht gebildet ist; und
jeder Gate-Stapel außerdem eine feuerfeste Metallsilicidschicht umfasst, die über der wenigstens einen leitenden Schicht und unter dem undotierten Siliciumdioxid gebildet wird.

44. Verfahren gemäß Anspruch 43, wobei Bereitstellen des Paars von Gate-Stapeln außerdem selektives Entfernen von Bereichen des undotierten Siliciumdioxids, der feuerfesten Metallsilicidschicht, der Polysiliciumschicht und der Gate-Oxidschicht umfasst.

45. Verfahren gemäß Anspruch 42, wobei der Gate-Stapel umfasst:
das im Wesentlichen undotierte Siliciumdioxid als Deckschicht davon;
eine feuerfeste Metallsilicidschicht;
eine Polysiliciumschicht und
eine Gate-Oxidschicht als eine Bodenschicht davon.

46. Verfahren gemäß Anspruch 42, wobei das Abstandhaltermaterial im Wesentlichen aus Siliciumnitrid besteht.

47. Verfahren gemäß Anspruch 42, wobei das Abstandhaltermaterial im Wesentlichen aus undotiertem Siliciumdioxid besteht.

48. Verfahren gemäß Anspruch 42, das außerdem Bilden eines Kontaktstöpsels, der im Wesentlichen aus einem leitenden Material besteht, umfasst, wobei der Kontaktstöpsel zwischen dem Paar von Gate-Stapeln und auf der Kontaktoberfläche gebildet wird.

49. Verfahren gemäß Anspruch 1, wobei Bereitstellen einer Struktur, einschließend einen ersten Bereich (14), der im Wesentlichen aus dotiertem Silicumdioxid besteht, und einen zweiten Bereich (16), der im Wesentlichen aus undotiertem Siliciumdioxid besteht, umfasst:
Bereitstellen eines Halbleitersubstrats;
Bereitstellen einer Mehrschichtstruktur über dem Halbleitersubstrat;
Abscheiden des zweiten Bereichs als eine Schicht über der Mehrschichtstruktur unter Verwendung eines Vorläufers, der einen Strom aus gasförmigem Silan, Wasserstoff und Sauerstoff aufweist;
Bilden einer ersten Photoresistschicht über dem zweiten Bereich;
Mustern der ersten Photoresistschicht unter Bildung eines ersten ausgewählten Musters;
Ätzen des zweiten Bereichs und der Mehrschichtstruktur durch das erste ausgewählte Muster, um eine Kontaktoberfläche auf dem Halbleitersubstrat freizulegen;
Entfernen der ersten Photoresistschicht;
Abscheiden einer Schicht aus nichtleitendem Material über sowohl dem zweiten Bereich als auch der Kontaktoberfläche;
Ätzen der Schicht aus nichtleitendem Material unter Bildung eines Abstandhalters über einer lateralen Seite des zweiten Bereichs und über einer lateralen Seite der Mehrschichtstruktur, wobei der Abstandhalter im Allgemeinen senkrecht zu dem Halbleitersubstrat ist;
Abscheiden des ersten Bereichs über sowohl der Mehrschichtstruktur als auch dem zweiten Bereich;
Bilden einer zweiten Photoresistschicht über dem ersten Bereich und
Mustern der zweiten Photoresistschicht unter Bildung eines zweiten ausgewählten Mustermaterials aus dem Abstandhalter und
wobei das Aussetzen sowohl des ersten Bereichs als auch des zweiten Bereichs dem Ätzverfahren mit Plasma hoher Dichte ein Durchführen des Ätzens mit Plasma hoher Dichte umfasst, wobei die Ausgangsleistungsdichte sowohl auf den ersten Bereich als auch auf den zweiten Bereich angewendet wird, wobei dotiertes Siliciumdioxid aus dem ersten Bereich selektiv durch das zweite ausgewählte Muster entfernt wird, um die Kontaktoberfläche freizulegen, wobei das dotierte Siliciumdioxid mit einer Materialentfernungsrate entfernt wird, die wenigstens 10-mal größer ist als die Materialentfernungsraten für jedes von undotiertem Siliciumdioxid aus dem zweiten Bereich, nichtleitendem Material aus dem Abstandhalter, halbleitendem Material aus dem Halbleitersubstrat und Photoresistmaterial aus der zweiten Photoresistschicht; und
außerdem ein Entfernen der zweiten Photoresistschicht und Bilden eines Kontaktstöpsels, der im Wesentlichen aus einem leitenden Material besteht, in Kontakt mit der Kontaktoberfläche umfasst.

50. Verfahren gemäß Anspruch 49, wobei das nichtleitende Material eines von Siliciumnitrid und im Wesentlichen undotiertem Siliciumdioxid ist.

51. Verfahren gemäß Anspruch 1, wobei die Mehrschichtstruktur aufeinander folgende Schichten von Gate-Oxid, Polysilicium und feuerfestem Metallsilicid umfasst.

52. Verfahren gemäß Anspruch 1, wobei Bereitstellen einer Struktur, einschließend einen ersten Bereich (14), der im Wesentlichen aus dotiertem Siliciumdioxid besteht, und einen zweiten Bereich (16), der im Wesentlichen aus undotiertem Siliciumdioxid besteht, umfasst:
Bereitstellen einer Mehrschichtstruktur über einem Halbleitersubstrat, wobei die Mehrschichtstruktur aufeinander folgende Schichten aus Gate-Oxid, Polysilicium und feuerfestem Metallsilicid umfasst;
Abscheiden des zweiten Bereichs als eine Schicht über der Mehrschichtstruktur unter Verwendung eines Vorläufers, der einen Strom aus gasförmigem Silan, Wasserstoff und Sauerstoff aufweist;
Bilden einer ersten Photoresistschicht über dem zweiten Bereich;
Mustern der ersten Photoresistschicht unter Bildung eines ersten ausgewählten Musters;
Ätzen des zweiten Bereichs und der Mehrschichtstruktur durch das erste ausgewählte Muster, um eine Kontaktoberfläche auf dem Halbleitersubstrat freizulegen;
Entfernen der ersten Photoresistschicht; Bilden einer Schicht eines nichtleitenden Materials über sowohl dem zweiten Bereich als auch der Kontaktoberfläche;
Ätzen der Schicht des nichtleitenden Materials unter Bildung eines Abstandhalters über einer lateralen Seite des zweiten Bereichs und über einer lateralen Seite der Mehrschichtstruktur, wobei der Abstandhalter im Allgemeinen senkrecht zu dem Halbleitersubstrat ist;
Bilden des ersten Bereichs als eine Schicht über sowohl der Mehrschichtstruktur als auch der Kontaktoberfläche;
Bilden einer zweiten Photoresistschicht über dem ersten Bereich;
Mustern der zweiten Photoresistschicht, um ein zweites ausgewähltes Mustermaterial aus dem Abstandhalter zu bilden; und
wobei ein Aussetzen sowohl des ersten als auch des zweiten Bereichs dem Ätzverfahren mit Plasma hoher Dichte ein Durchführen des Ätzens mit Plasma hoher Dichte umfasst, wobei eine Ausgangsleistungsdichte sowohl auf den ersten Bereich als auch auf den zweiten Bereich angewendet wird, wobei dotiertes Siliciumdioxid aus dem ersten Bereich selektiv durch das zweite ausgewählte Muster entfernt wird, um die Kontaktoberfläche freizulegen, wobei das dotierte Siliciumdioxid mit einer Materialentfernungsrate entfernt wird, die wenigstens 10-mal größer ist als die Materialentfernungsraten für jedes von undotiertem Siliciumdioxid aus dem zweiten Bereich, nichtleitendem Material aus dem Abstandhalter, halbleitendem Material aus dem Halbleitersubstrat und Photoresistmaterial aus der zweiten Photoresistschicht; und
außerdem Entfernen der zweiten Photoresistschicht und Bilden eines Kontaktstöpsels, der im Wesentlichen aus einem leitenden Material besteht, im Kontakt mit der Kontaktoberfläche umfasst.

53. Verfahren gemäß Anspruch 1, wobei Bereitstellen einer Struktur, einschließend einen ersten Bereich (14), der im Wesentlichen aus dotiertem Siliciumdioxid besteht, und einen zweiten Bereich (16), der im Wesentlichen aus undotiertem Siliciumdioxid besteht, umfasst:
Bereitstellen eines Halbleitersubstrats;
Bereitstellen eines Paars von Gate-Stapeln in beabstandeter Beziehung zueinander auf dem Halbleitersubstrat, wobei jeder der Gate-Stapel von einer undotierten Siliciumdioxidschicht, die den zweiten Bereich bildet, bedeckt ist;
Bilden eines Abstandhalters, benachbart zu jedem der Gate-Stapel;
Bilden des ersten Bereichs als eine Schicht über dem Paar von Gate-Stapeln und über dem Halbleitersubstrat;
Bilden einer Photoresistschicht über dem ersten Bereich und
Bereitstellen eines Musters in der Photoresistschicht; und
wobei das Aussetzen sowohl des ersten Bereichs als auch des zweiten Bereichs dem Ätzverfahren mit Plasma hoher Dichte ein Durchführen des Ätzens mit Plasma hoher Dichte umfasst, wobei eine Ausgangsleistungsdichte sowohl auf den ersten Bereich als auch auf den zweiten Bereich angewendet wird, wobei dotiertes Siliciumdioxid aus der dotierten Siliciumdioxidschicht zwischen dem Paar von Gate-Stapeln und durch das Muster selektiv entfernt wird, um eine selbst-ausgerichtete Kontaktöffnung zu bilden, die sich zu der Kontaktoberfläche erstreckt, wobei dotiertes Siliciumdioxid mit einer wesentlich größere Materialentfernungsrate als die für undotiertes Siliciumdioxid aus der undotierten Siliciumdioxidschicht entfernt wird, wobei die undotierte Siliciumschicht im Wesentlichen gegenüber dem Ätzen mit Plasma hoher Dichte beständig ist.

## Revendications

1. Procédé d'élimination de dioxyde de silicium dopé, ledit procédé comprenant :
la fourniture d'une structure comprenant une première partie (14) essentiellement composée de dioxyde de silicium dopé et une seconde partie (16) essentiellement composée de dioxyde de silicium non dopé, dans laquelle le dioxyde de silicium dopé a une concentration en dopant supérieure ou égale à environ 3 % en poids et le dioxyde de silicium non dopé a une concentration en dopant inférieure à environ 3 % en poids ; et
l'exposition de ladite première partie et de ladite seconde partie à un procédé de gravure par plasma pour éliminer sélectivement le dioxyde de silicium dopé de ladite première partie à une vitesse d'élimination de matière qui est supérieure à la vitesse d'élimination de matière du dioxyde de silicium non dopé de ladite seconde partie, **caractérisé en ce que** le procédé de gravure par plasma est un procédé de gravure par plasma à haute densité comprenant une densité ionique supérieure à environ 10⁹ ions/cm³ et une densité de puissance source inférieure à environ 1 000 Watts par surface de tranche de 200 mm de diamètre.

2. Procédé selon la revendication 1, dans lequel ladite première partie (14) est en contact avec ladite seconde partie (16).

3. Procédé selon la revendication 1, dans lequel ledit dioxyde de silicium dopé est éliminé à une vitesse d'élimination de matière qui est au moins 10 fois plus élevée que la vitesse d'élimination de matière dudit dioxyde de silicium non dopé.

4. Procédé selon la revendication 1, dans lequel l'exposition de ladite première partie (14) et de ladite seconde partie (16) à un procédé de gravure par plasma à haute densité comprend :
le placement de ladite structure à l'intérieur d'une chambre d'une chambre à plasma à haute densité (10).

5. Procédé selon la revendication 1, dans lequel le procédé de gravure par plasma à haute densité est mené au moyen d'un décapant chimique fluoré.

6. Procédé selon la revendication 1, dans lequel l'exposition de ladite première partie (14) et de ladite seconde partie (16) à un procédé de gravure par plasma à haute densité comprend :
le placement de ladite structure à l'intérieur d'une chambre d'une chambre à plasma à haute densité possédant une électrode supérieure (11); et
l'application de la densité de puissance source inférieure à environ 1 000 Watts par tranche de 200 mm de diamètre à ladite électrode supérieure.

7. Procédé selon la revendication 1, dans lequel ladite structure possède une surface ayant une superficie définie par 0,000245 X m² (X pouce²), et dans lequel l'exposition de ladite première partie (14) et de ladite seconde partie (16) à un procédé de gravure par plasma à haute densité comprend :
le placement de ladite structure à l'intérieur d'une chambre d'une chambre à plasma à haute densité possédant une électrode supérieure (11) et une électrode inférieure (13) ; et
l'application d'une puissance source à ladite électrode supérieure et d'une puissance de polarisation à ladite électrode inférieure de manière à ce que la densité de puissance source inférieure à environ 1 000 Watts (W) par surface de tranche de 200 mm de diamètre soit fournie à ladite superficie de ladite surface de ladite structure, ladite puissance de polarisation étant appliquée dans une plage d'environ 100 Watts inférieurs à ladite puissance source à environ 200 Watts supérieurs à ladite puissance source.

8. Procédé selon la revendication 7, dans lequel la puissance de polarisation est appliquée dans une plage d'environ 100 Watts inférieurs à ladite puissance source à environ 200 Watts supérieurs à ladite puissance source.

9. Procédé selon la revendication 7, dans lequel ladite puissance de polarisation est environ égale à ladite puissance source.

10. Procédé selon la revendication 1, dans lequel ladite vitesse d'élimination de matière dudit dioxyde de silicium dopé est dans une plage d'environ 500 nm/minute à environ 1 000 nm/minute (environ 5 000 Å/minute à environ 10 000 Å/minute).

11. Procédé selon la revendication 1, dans lequel l'exposition de ladite première partie (14) et de ladite seconde partie (16) au procédé de gravure par plasma à haute densité comprend :
le placement de ladite structure à l'intérieur d'une chambre d'une chambre à plasma à haute densité ; et
l'exposition de ladite structure à un produit chimique de gravure comprenant C₂HF₅, CHF₃ et CH₂F₂ à une pression inférieure à environ 0,67 Pa (5 millitorr).

12. Procédé selon la revendication 1, dans lequel l'exposition de ladite première partie (14) et de ladite seconde partie (16) aux procédés de gravure par plasma à haute densité comprend :
le placement de ladite structure à l'intérieur d'une chambre d'une chambre à plasma à haute densité possédant une électrode inférieure refroidie par un fluide ayant une température dans la plage d'environ 0 °C à environ 40 °C.

13. Procédé selon la revendication 1, dans lequel ladite couche de dioxyde de silicium dopé est dopée avec du bore à une concentration d'au moins 3 % en poids.

14. Procédé selon la revendication 1, dans lequel ladite couche de dioxyde de silicium dopé est dopée avec du phosphore à une concentration d'au moins 3 % en poids.

15. Procédé selon la revendication 1, dans lequel ladite couche de dioxyde de silicium non dopé est en contact avec au plus 3 % en poids de bore et contient au plus 3 % en poids de phosphore.

16. Procédé selon la revendication 1, comprenant en outre le placement de ladite structure dans une chambre d'un dispositif de gravure à haute densité possédant une électrode supérieure (11) et une électrode inférieure (13) ; et
dans lequel l'exposition de ladite première partie (14) et de ladite seconde partie (16) à un procédé de gravure par plasma à haute densité comprend :
l'application d'une puissance source à l'électrode supérieure (11) du dispositif de gravure à haute densité (10) et
l'application d'une puissance de polarisation à l'électrode inférieure (13) du dispositif de gravure à haute densité, ladite puissance de polarisation étant dans une plage d'environ 200 Watts inférieurs à ladite puissance source à environ 200 Watts supérieurs à ladite puissance source, de sorte que ledit dioxyde de silicium dopé est éliminé sélectivement à une vitesse d'élimination de matière qui est au moins 10 fois plus élevée que la vitesse d'élimination de matière dudit dioxyde de silicium non dopé, ladite vitesse d'élimination de matière dudit dioxyde de silicium dopé étant dans une plage d'environ 500 nm/minute à environ 1 000 nm/minute (environ 5 000 Å/minute à environ 10 000 Å/minute).

17. Procédé selon la revendication 1, comprenant en outre le placement de ladite structure dans une chambre d'un dispositif de gravure à haute densité (10) possédant une électrode supérieure (11) et une électrode inférieure (13) ; et
dans lequel l'exposition de ladite première partie (14) et de ladite seconde partie (16) à un procédé de gravure par plasma à haute densité comprend :
l'introduction d'un décapant choisi dans le groupe constitué par C₂F₆, CF₄, C₃F₈, C₄F₁₀, CH₂F₂, CHF₃, C₂HF₅ et CH₃F ;
l'application d'une puissance source à l'électrode supérieure (11) du dispositif de gravure à haute densité ;
l'application d'une puissance de polarisation à l'électrode inférieure (13) du dispositif de gravure à haute densité, ladite puissance de polarisation étant dans une plage d'environ 200 Watts inférieurs à ladite puissance source à environ 200 Watts supérieurs à ladite puissance source ; et
la fourniture de la densité de puissance source à la surface de ladite structure, ledit dioxyde de silicium dopé étant éliminé sélectivement à une vitesse d'élimination de matière qui est au moins 10 fois plus élevée que la vitesse d'élimination de matière dudit dioxyde de silicium non dopé, ladite vitesse d'élimination de matière dudit dioxyde de silicium dopé étant dans une plage d'environ 500 nm/minute à environ 1 000 nm/minute (environ 5 000 Å/minute à environ 10 000 Å/minute).

18. Procédé selon la revendication 1, dans lequel la fourniture d'une structure comprenant une première partie (14) essentiellement composée de dioxyde de silicium dopé et une seconde partie (16) essentiellement composée de dioxyde de silicium non dopé comprend :
la formation d'une première couche supportée par un substrat, ladite première couche étant ladite première partie ;
la formation d'une seconde couche supportée par ladite première couche, ladite seconde couche étant ladite seconde partie ; et
la formation d'une ouverture à travers ladite seconde partie pour exposer une surface sur ladite première partie ; et
dans lequel l'exposition de ladite première partie (14) et de ladite seconde partie (16) au procédé de gravure par plasma à haute densité comprend :
le fait de mener la gravure par plasma à haute densité à la fois sur ladite première partie et ladite seconde partie pour éliminer sélectivement le dioxyde de silicium dopé de ladite première partie à travers ladite ouverture à une vitesse d'élimination de matière qui est supérieure à la vitesse d'élimination de matière du dioxyde de silicium non dopé de ladite seconde partie.

19. Procédé selon la revendication 18, dans lequel le procédé de gravure par plasma à haute densité comprend la gravure dudit dioxyde de silicium dopé avec un décapant choisi dans le groupe constitué par C₂F₆, CF₄, C₃F₈, C₄F₁₀, CH₂F₂, CHF₃, C₂HF₅ et CH₃F.

20. Procédé selon la revendication 18, comprenant en outre la formation d'au moins une couche d'intercalation positionnée entre ladite première couche (14) et ladite seconde couche (16).

21. Procédé selon la revendication 20, dans lequel ladite au moins une couche d'intercalation est essentiellement composée d'au moins un matériau choisi dans un groupe constitué par les siliciures de molybdène, de chrome, de tungstène, de titane, de tantale, de platine et de zirconium.

22. Procédé selon la revendication 20, dans lequel ladite au moins une couche d'intercalation est essentiellement composée de polysilicium.

23. Procédé selon la revendication 18, dans lequel le fait de mener ladite gravure par plasma à haute densité comprend l'exposition d'une surface d'un substrat sur lequel la première partie (14) et la seconde partie (16) sont présentes.

24. Procédé selon la revendication 18, comprenant en outre la formation d'une couche d'arrêt de gravure avant la formation de ladite première partie, ladite couche d'arrêt de gravure étant supportée par ledit substrat et essentiellement composée de dioxyde de silicium non dopé, une partie de ladite couche d'arrêt de gravure étant exposée à ladite gravure par plasma à haute densité.

25. Procédé selon la revendication 20, dans lequel ladite au moins une couche d'intercalation comprend :
une couche de polysilicium ; et
une couche de siliciure métallique réfractaire.

26. Procédé selon la revendication 25, dans lequel ladite couche de siliciure métallique réfractaire est essentiellement composée de siliciure de tungstène.

27. Procédé selon la revendication 1, dans lequel la fourniture d'une structure comprenant une première partie (14) essentiellement composée de dioxyde de silicium dopé et une seconde partie (16) essentiellement composée de dioxyde de silicium non dopé comprend :
la formation d'une première couche sur un substrat semi-conducteur, ladite première couche étant ladite première partie ;
la formation d'une seconde couche supportée par ladite première couche, ladite seconde couche étant ladite seconde partie ;
la fourniture d'un motif se prolongeant à travers ladite seconde partie, une partie de ladite première partie sous ledit motif étant exposée ;
et dans lequel l'exposition de ladite première partie et de ladite seconde partie au procédé de gravure par plasma à haute densité comprend :
le fait de mener la gravure par plasma à haute densité à la fois sur ladite première partie et ladite seconde partie, la densité de puissance source étant appliquée à la fois à ladite première partie et à ladite seconde partie pour éliminer sélectivement le dioxyde de silicium dopé de ladite première partie à travers ledit motif pour former une ouverture dans ladite première partie, ladite ouverture étant définie par une surface de contact exposée sur ledit substrat semi-conducteur et une paroi latérale sensiblement orthogonale à ladite surface de contact exposée.

28. Procédé selon la revendication 27, comprenant en outre une fiche de contact essentiellement composée d'un matériau conducteur sur ladite surface exposée à l'intérieur de ladite ouverture.

29. Procédé selon la revendication 1, dans lequel la fourniture d'une structure comprenant une première partie essentiellement composée de dioxyde de silicium dopé et une seconde partie essentiellement composée de dioxyde de silicium non dopé comprend :
la fourniture d'une structure multicouche possédant :
- une première couche (14) supportée par un substrat, ladite première couche étant ladite première partie ; et
- une seconde couche (16) supportée par ladite première couche, ladite seconde couche étant ladite seconde partie ;
la formation d'une ouverture primaire et d'une ouverture secondaire dans ladite seconde partie, ladite ouverture primaire et ladite ouverture secondaire se prolongeant vers ladite première partie ;
la formation d'une couche de réserve sur ladite seconde partie, ladite couche de réserve remplissant au moins partiellement ladite ouverture secondaire et ne remplissant essentiellement pas ladite ouverture primaire ; et
dans lequel l'exposition de ladite première partie et de ladite seconde partie au procédé de gravure par plasma à haute densité comprend :
le fait de mener la gravure par plasma à haute densité à la fois sur ladite première partie et ladite seconde partie à travers ladite ouverture primaire, la densité de puissance source étant appliquée à la fois à ladite première partie et à ladite seconde partie, ledit dioxyde de silicium dopé étant sélectivement éliminé de ladite première partie à travers ladite ouverture primaire à une vitesse d'élimination de matière qui est supérieure aux vitesses d'élimination de matière du dioxyde de silicium non dopé de ladite seconde partie et du matériau de réserve de ladite couche de réserve.

30. Procédé selon la revendication 1, dans lequel la fourniture d'une structure comprenant une première partie (14) essentiellement composée de dioxyde de silicium dopé et une seconde partie (16) essentiellement composée de dioxyde de silicium non dopé comprend :
la formation d'une première série d'empilements de grille supportés par un substrat ;
la formation de la première partie sous la forme d'une première couche sur ladite première série d'empilements de grille ;
la formation d'une seconde série d'empilements de grille supportés par ladite première partie, ladite seconde série définissant au moins un espace entre deux empilements de grille adjacents de ladite seconde série, chacun desdits empilements de grille de ladite seconde série comprenant :
- une couche de dioxyde de silicium non dopé constituant ladite seconde partie qui définit une surface supérieure sur chacun desdits empilements de grille de ladite seconde série ; et
- un espaceur en contact avec ladite couche de dioxyde de silicium non dopé, ledit espaceur définissant une surface latérale sur chacun desdits empilements de grille de ladite seconde série ; et
dans lequel l'exposition de ladite première partie et de ladite seconde partie au procédé de gravure par plasma à haute densité comprend :
le fait de mener la gravure par plasma à haute densité à la fois sur ladite première partie et ladite seconde partie, la densité de puissance source étant appliquée à la fois à ladite première partie et à ladite seconde partie pour éliminer sélectivement le dioxyde de silicium dopé de ladite première partie à travers au moins une ouverture à une vitesse d'élimination de matière qui est supérieure à la vitesse d'élimination de matière du dioxyde de silicium non dopé de ladite seconde partie.

31. Procédé selon la revendication 30, dans lequel ledit espaceur est essentiellement composé de dioxyde de silicium non dopé et le dioxyde de silicium dopé est sélectivement éliminé dudit dioxyde de silicium dopé à une vitesse d'élimination de matière qui est supérieure à la vitesse d'élimination de matière du dioxyde de silicium non dopé dudit espaceur.

32. Procédé selon la revendication 30, dans lequel lesdits empilements de grille de ladite première série sont parallèles les uns aux autres, ladite première série définissant un premier composant directionnel ; et
lesdits empilements de grille de ladite seconde série sont parallèles les uns aux autres, ladite seconde série définissant un second composant directionnel.

33. Procédé selon la revendication 32, dans lequel ledit premier composant directionnel est sensiblement parallèle audit second composant directionnel.

34. Procédé selon la revendication 32, dans lequel ledit premier composant directionnel est sensiblement orthogonal audit second composant directionnel.

35. Procédé selon la revendication 30, dans lequel chacun desdits empilements de grille de ladite première série comprend :
une couche d'oxyde de grille supportée par ledit substrat ;
une couche de polysilicium sur ladite couche d'oxyde de grille ;
une couche de siliciure métallique réfractaire sur ladite couche de polysilicium ;
une couche de dioxyde de silicium non dopé sur ladite couche de siliciure métallique réfractaire ; et
un espaceur essentiellement composé de dioxyde de silicium non dopé, ledit espaceur étant en contact à avec ladite couche d'oxyde de grille, ladite couche de polysilicium, ladite couche de siliciure métallique réfractaire et ladite couche de dioxyde de silicium non dopé.

36. Procédé selon la revendication 35, dans lequel ladite couche de siliciure métallique réfractaire de chacun desdits empilements de grille est essentiellement composée de siliciure de tungstène.

37. Procédé selon la revendication 1, dans lequel la fourniture d'une structure comprenant une première partie (14) essentiellement composée de dioxyde de silicium dopé et une seconde partie (16) essentiellement composée de dioxyde de silicium non dopé comprend :
la formation de la seconde partie sous la forme d'une couche sur un substrat semi-conducteur ;
la formation de la première partie sous la forme d'une couche sur ladite seconde partie ; et
dans lequel l'exposition de ladite première partie et de ladite seconde partie au procédé de gravure par plasma à haute densité comprend :
le fait de mener la gravure par plasma à haute densité à la fois sur ladite première partie et ladite seconde partie, la densité de puissance source étant appliquée à la fois à ladite première partie et à ladite seconde partie, ledit dioxyde de silicium dopé étant sélectivement éliminé de ladite première partie pour exposer une partie de ladite seconde partie, ledit dioxyde de silicium dopé étant éliminé à une vitesse d'élimination de matière qui est supérieure à la vitesse d'élimination de matière du dioxyde de silicium non dopé de ladite seconde couche.

38. Procédé selon la revendication 37, comprenant en outre :
la formation d'une couche de réserve sur ladite première partie (14) ;
la fourniture d'un motif dans ladite couche de réserve ; et
le fait de mener ladite gravure par plasma à haute densité pour éliminer ledit dioxyde de silicium dopé à travers ledit motif dans ladite couche de réserve.

39. Procédé selon la revendication 37, dans lequel une surface dudit substrat semi-conducteur est exposée quand ladite gravure par plasma à haute densité est réalisée, ladite vitesse d'élimination de matière dudit dioxyde de silicium dopé étant au moins 10 fois plus élevées que la vitesse d'élimination de matière d'un matériau semi-conducteur dudit substrat semi-conducteur.

40. Procédé selon la revendication 37, dans lequel ledit matériau semi-conducteur est essentiellement composé de silicium monocristallin.

41. Procédé selon la revendication 37, dans lequel ladite gravure par plasma à haute densité est menée à une pression de fonctionnement dans une plage d'environ 133 mPa à environ 1,33 Pa (environ 1 millitorr à environ 10 millitorr).

42. Procédé selon la revendication 1, dans lequel la fourniture d'une structure comprenant une première partie (14) essentiellement composée de dioxyde de silicium dopé et une seconde partie (16) essentiellement composée de dioxyde de silicium non dopé comprend :
la fourniture d'une couche d'oxyde de grille sur un substrat semi-conducteur composé d'un matériau semi-conducteur ;
la fourniture d'une paire d'empilements de grille espacés l'un de l'autre sur ladite couche d'oxyde de grille, au moins une couche conductrice étant formée dans chacun desdits empilements de grille et la seconde partie de dioxyde de silicium non dopé se prolongeant sur ladite couche conductrice, une surface de contact sur ledit substrat semi-conducteur étant positionnée entre ladite paire d'empilements de grille ;
la formation d'un espaceur composé d'un matériau d'espaceur à proximité de chacun desdits empilements de grille ;
la formation de la première partie de dioxyde de silicium dopé sous la forme d'une couche sur ladite paire d'empilements de grille et sur ladite surface de contact ; et
dans lequel l'exposition de ladite première partie et de ladite seconde partie au procédé de gravure par plasma à haute densité comprend le fait de mener la gravure par plasma à haute densité, dans laquelle la densité de puissance source est appliquée à la fois à ladite première partie et à ladite seconde partie pour former une ouverture de contact se prolongeant sur ladite surface de contact, ledit dioxyde de silicium dopé étant éliminé à une vitesse d'élimination de matière qui est au moins 10 fois plus élevée que les vitesses d'élimination de matière du dioxyde de silicium non dopé de ladite seconde partie, dudit matériau d'espaceur dudit espaceur et dudit matériau semi-conducteur dudit substrat semi-conducteur.

43. Procédé selon la revendication 42, dans lequel :
ladite au moins une couche conductrice comprend une couche de polysilicium formée sur ladite couche d'oxyde de grille ; et
chacun desdits empilements de grille comprend en outre une couche de siliciure métallique réfractaire formée sur ladite au moins une couche conductrice et sous ledit dioxyde de silicium non dopé.

44. Procédé selon la revendication 43, dans lequel la fourniture de ladite paire d'empilements de grille comprend en outre l'élimination sélective des parties dudit dioxyde de silicium non dopé, de ladite couche de siliciure métallique réfractaire, de ladite couche de polysilicium et de ladite couche d'oxyde de grille.

45. Procédé selon la revendication 42, dans lequel ledit empilement de grille comprend :
ledit dioxyde de silicium essentiellement non dopé sous la forme d'une couche supérieure de celui-ci ;
une couche de siliciure métallique réfractaire ;
une couche de polysilicium ; et
une couche d'oxyde de grille sous la forme d'une couche inférieure de celui-ci.

46. Procédé selon la revendication 42, dans lequel ledit matériau d'espaceur est essentiellement composé de nitrure de silicium.

47. Procédé selon la revendication 42, dans lequel le matériau d'espaceur est essentiellement composé de dioxyde de silicium non dopé.

48. Procédé selon la revendication 42, comprenant en outre la formation d'une fiche de contact essentiellement composée d'un matériau conducteur, ladite fiche de contact étant formée entre ladite paire d'empilements de grille et sur ladite surface de contact.

49. Procédé selon la revendication 1, dans lequel la fourniture d'une structure comprenant une première partie (14) essentiellement composée de dioxyde de silicium dopé et une seconde partie (16) essentiellement composée de dioxyde de silicium non dopé comprend :
la fourniture d'un substrat semi-conducteur ;
la fourniture d'une structure multicouche sur ledit substrat semi-conducteur ;
le dépôt de la seconde partie sous la forme d'une couche sur ladite structure multicouche en utilisant un précurseur ayant un flux gazeux de silane, d'hydrogène et d'oxygène ;
la formation d'une première couche de réserve sur ladite seconde partie ;
la formation d'un motif sur ladite première couche de réserve pour former un premier motif sélectionné ;
la gravure de ladite seconde partie et de ladite structure multicouche à travers ledit premier motif sélectionné pour exposer une surface de contact sur ledit substrat semi-conducteur ;
l'élimination de ladite première couche de réserve ;
le dépôt d'une couche de matériau non conducteur à la fois sur ladite seconde partie et ladite surface de contact ;
la gravure de ladite couche de matériau non conducteur pour former un espaceur sur un côté latéral de ladite seconde partie et sur un côté latéral de ladite structure multicouche, ledit espaceur étant généralement perpendiculaire audit substrat semi-conducteur ;
le dépôt de la première partie à la fois sur ladite structure multicouche et ladite seconde partie ;
la formation d'une seconde couche de réserve sur ladite première partie ; et
la formation d'un motif sur ladite seconde couche de réserve pour former un second matériau de motif sélectionné à partir dudit espaceur ; et
dans lequel l'exposition de ladite première partie et de ladite seconde partie au procédé de gravure par plasma à haute densité comprend le fait de mener la gravure par plasma à haute densité, dans laquelle la densité de puissance source est appliquée à la fois à ladite première partie et à ladite seconde partie, le dioxyde de silicium dopé étant sélectivement éliminé de la première partie à travers ledit second motif sélectionné pour exposer ladite surface de contact, ledit dioxyde de silicium dopé étant éliminé à une vitesse d'élimination de matière qui est au moins 10 fois plus élevée que les vitesses d'élimination de matière du dioxyde de silicium non dopé de ladite seconde partie, du matériau non conducteur dudit espaceur, du matériau semi-conducteur dudit substrat semi-conducteur et du matériau de réserve de ladite seconde couche de réserve ; et
comprenant en outre l'élimination de ladite seconde couche de réserve et la formation d'une fiche de contact essentiellement composée d'un matériau conducteur en contact avec ladite surface de contact.

50. Procédé selon la revendication 49, dans lequel ledit matériau non conducteur est un matériau choisi parmi le nitrure de silicium et le dioxyde de silicium sensiblement non dopé.

51. Procédé selon la revendication 1, dans lequel ladite structure multicouche comprend des couches successives d'oxyde de grille, de polysilicium et de siliciure métallique réfractaire.

52. Procédé selon la revendication 1, dans lequel la fourniture d'une structure comprenant une première partie (14) essentiellement composée de dioxyde de silicium dopé et une seconde partie (16) essentiellement composée de dioxyde de silicium non dopé comprend :
la fourniture d'une structure multicouche sur un substrat semi-conducteur, ladite structure multicouche comprenant des couches successives d'oxyde de grille, de polysilicium et de siliciure métallique réfractaire ;
le dépôt de la seconde partie sous la forme d'une couche sur ladite structure multicouche en utilisant un précurseur ayant un flux gazeux de silane, d'hydrogène et d'oxygène ;
la formation d'une première couche de réserve sur ladite seconde partie ;
la formation d'un motif sur ladite première couche de réserve pour former un premier motif sélectionné ;
la gravure de ladite seconde partie et de ladite structure multicouche à travers ledit premier motif sélectionné pour exposer une surface de contact sur ledit substrat semi-conducteur ;
l'élimination de ladite première couche de réserve ;
la formation d'une couche de matériau non conducteur à la fois sur ladite seconde partie et ladite surface de contact ;
la gravure de ladite couche dudit matériau non conducteur pour former un espaceur sur un côté latéral de ladite seconde partie et sur un côté latéral de ladite structure multicouche, ledit espaceur étant généralement perpendiculaire audit substrat semi-conducteur ;
la formation de la première partie sous la forme d'une couche à la fois sur ladite structure multicouche et ladite surface de contact ;
la formation d'une seconde couche de réserve sur ladite première partie ;
la formation d'un motif sur ladite seconde couche de réserve pour former un second matériau de motif sélectionné à partir dudit espaceur ; et
dans lequel l'exposition de ladite première partie et de ladite seconde partie au procédé de gravure par plasma à haute densité comprend le fait de mener la gravure par plasma à haute densité, dans laquelle une densité de puissance source est appliquée à la fois à ladite première partie et à ladite seconde partie, le dioxyde de silicium dopé étant sélectivement éliminé de ladite première partie à travers ledit second motif sélectionné pour exposer ladite surface de contact, ledit dioxyde de silicium dopé étant éliminé à une vitesse d'élimination de matière qui est au moins 10 fois plus élevée que les vitesses d'élimination de matière du dioxyde de silicium non dopé de ladite seconde partie, du matériau non conducteur dudit espaceur, du matériau semi-conducteur dudit substrat semi-conducteur et du matériau de réserve de ladite seconde couche de réserve ; et
comprenant en outre l'élimination de ladite seconde couche de réserve et la formation d'une fiche de contact essentiellement composée d'un matériau conducteur en contact avec ladite surface de contact.

53. Procédé selon la revendication 1, dans lequel la fourniture d'une structure comprenant une première partie (14) essentiellement composée de dioxyde de silicium dopé et une seconde partie (16) essentiellement composée de dioxyde de silicium non dopé comprend :
la fourniture d'un substrat semi-conducteur ;
la fourniture d'une paire d'empilements de grille espacés l'un de l'autre sur ledit substrat semi-conducteur, chacun desdits empilements de grille étant recouvert par une couche de dioxyde de silicium non dopé constituant ladite seconde partie ;
la formation d'un espaceur à proximité de chacun desdits empilements de grille ;
la formation de ladite première partie sous la forme d'une couche sur ladite paire d'empilements de grille et sur ledit substrat semi-conducteur ;
la formation d'une couche de réserve sur ladite première partie ; et
la fourniture d'un motif sur ladite couche de réserve ; et
dans lequel l'exposition de ladite première partie et de ladite seconde partie au procédé de gravure par plasma à haute densité comprend le fait de mener la gravure par plasma à haute densité, dans laquelle une densité de puissance source est appliquée à la fois à ladite première partie et à ladite seconde partie, le dioxyde de silicium dopé étant éliminé sélectivement de ladite couche de dioxyde de silicium dopé entre ladite paire d'empilements de grille et à travers ledit motif pour former une ouverture de contact auto-alignée se prolongeant sur ladite surface de contact, le dioxyde de silicium dopé étant éliminé à une vitesse d'élimination de matière sensiblement supérieure à celle du dioxyde de silicium non dopé de ladite couche de dioxyde de silicium non dopé, ladite couche de silicium non dopé résistant sensiblement à ladite gravure par plasma à haute densité.
